# EUROPEAN PATENT APPLICATION

(11) **EP 4 715 277 A1**
(43) Date of publication of application: **25.03.2026**
(21) Application number: 24858751.1
(22) Date of filing: 30.08.2024
(51) Int. Cl.: F24F 1/24

(54) **ELECTRIC CONTROL MODULE ASSEMBLY, POTTING METHOD, OUTDOOR UNIT, AND HEATING, VENTILATION AND AIR CONDITIONING EQUIPMENT**

(30) Priority: 01.09.2023 CN 202311128861; 01.09.2023 CN 202311128895
(71) Applicant: GD Midea Heating & Ventilating Equipment Co., Ltd., Foshan, Guangdong 528311 (CN); Hefei Midea Heating & Ventilating Equipment Co., Ltd., Hefei, Anhui 230088 (CN)
(72) Inventor: WU, Yandong, Foshan, Guangdong 528311 (CN); LI, Dongpo, Foshan, Guangdong 528311 (CN); SUN, Panpan, Foshan, Guangdong 528311 (CN); CHEN, Kebi, Foshan, Guangdong 528311 (CN)
(74) Representative: RGTH
(86) International application number: PCT/CN2024/115993
(87) International publication number: WO 2025/045222

(57) **Abstract**

Provided are an electric control module assembly (10), a potting method, an outdoor unit (100), and a heating, ventilation and air conditioning equipment. The electric control module assembly (10) includes an electric control module (20) and a heat dissipation component (30). The electric control module (20) includes an electric control box (24) and an electric control component (21) disposed in the electric control box (24). The electric control component (21) includes an electric control board (22) and a plurality of electronic components (23) disposed at the electric control board (22). The heat dissipation component (30) is configured to dissipate heat from the electric control module (20). The electric control box (24) is internally provided with an isolation structure encapsulating outer surfaces of the plurality of electronic components (23) to isolate the electronic component (23) from air.

## Description

### CROSS-REFERENCE TO RELATED APPLICATIONS

This application claims priorities to Chinese Patent Applications No. 202311128861.3 and No. 202311128895.2, both filed on September 01, 2023, the entire disclosure of which are incorporated herein by reference.

### FIELD

The present disclosure relates to the technical field of electric control heat dissipation, and in particular, to an electric control module assembly, a potting method, an outdoor unit, and a heating, ventilation and air conditioning equipment.

### BACKGROUND

**In** the related art, an electric control module generates a large amount of heat during its operation. In order to ensure stable operation of the electric control module, heat dissipation and cooling are usually performed on the electric control module. For example, a heat dissipation component is adopted to be in thermally conductive connection with electronic components of the electric control module, and heat generated by the electronic components is transferred to the heat dissipation component, and dissipated through the heat dissipation component, achieving heat dissipation for the electric control module.

However, during the heat dissipation and cooling of the electric control module by the heat dissipation component, generation of condensation may be caused at the electronic components of the electric control module, which affects reliability, stability, and safety of the electric control module. Therefore, an improvement is required.

### SUMMARY

The present disclosure aims to solve at least one of the technical problems existing in the related art. To this end, an objective of the present disclosure is to provide an electric control module assembly. By providing a heat dissipation component, heat dissipation may be performed on an electric control module. Moreover, an isolation structure is provided and encapsulates outer surfaces of electronic components to isolate the electronic components from air, and thus prevent condensation from being generated at the electronic components of the electric control module, improving reliability, stability, and safety of the electric control module. In addition, when flammable and explosive gas is present in an environment where the electric control module is located, the isolation structure is provided and encapsulates the outer surfaces of the electronic components, which can eliminate safety hazards of ignition and explosion caused by contact between the flammable and explosive gas and the electronic components, while achieving effects of improving vibration resistance performance of the electric control module, preventing disengagement of the electronic components, buffering and protecting the electronic components, and dust prevention.

The present disclosure provides a potting method of the electric control module assembly described above.

The present disclosure provides an outdoor unit having the electric control module assembly described above.

The present disclosure also provides a heating, ventilation and air conditioning equipment having the outdoor unit described above.

An electric control module assembly according to an embodiment of a first aspect of the present disclosure comprises an electric control module and a heat dissipation component. The electric control module comprises an electric control box and an electric control component disposed in the electric control box. The electric control component comprises an electric control board and a plurality of electronic components disposed at the electric control board. The heat dissipation component is configured to dissipate heat from the electric control module. The electric control box is internally provided with an isolation structure encapsulating outer surfaces of the plurality of electronic components.

With the electric control module assembly according to the embodiment of the present disclosure, by providing the heat dissipation component, the heat dissipation may be performed on the electric control module. Moreover, the isolation structure is provided and encapsulates the outer surfaces of the electronic components to isolate the electronic components from the air, and thus prevent the condensation from being generated at the electronic components of the electric control module, improving the reliability, stability, and safety of the electric control module. In addition, when the flammable and explosive gas is present in the environment where the electric control module is located, the isolation structure is provided and encapsulates the outer surfaces of the electronic components, which can eliminate the safety hazards of the ignition and explosion caused by the contact between the flammable and explosive gas and the electronic components, while achieving the effects of improving the vibration resistance performance of the electric control module, preventing the disengagement of the electronic components, buffering and protecting the electronic components, and the dust prevention.

According to some embodiments of the present disclosure, the isolation structure is a gel structure.

According to some embodiments of the present disclosure, a part of the heat dissipation component is located in the electric control box and is in thermally conductive connection with the electric control component; and a space defined by the electric control box, the electric control component, and the heat dissipation component is filled with the isolation structure. The electric control component and the part of the heat dissipation component are connected into one piece by the isolation structure.

According to some embodiments of the present disclosure, an inner wall of the electric control box or the electric control board is provided with a first limiting structure configured to limit a position of the part of the heat dissipation component.

According to some embodiments of the present disclosure, the electric control board has a first side and a second side opposite to each other in a thickness direction of the electric control board. A filling space is defined between the first side of the electric control board and the electric control box, at least part of the plurality of electronic components are disposed at the first side of the electric control board and located in the filling space, and the filling space is filled with the isolation structure.

According to some embodiments of the present disclosure, a part of the heat dissipation component is located in the filling space and is in thermally conductive connection with the plurality of electronic components.

According to some embodiments of the present disclosure, the isolation structure is filled between an outer edge of the electric control board and an inner wall of the electric control box.

According to some embodiments of the present disclosure, the plurality of electronic components are mounted at the first side of the electric control board; and a surface of the second side of the electric control board serves as a board back surface exposing welding pins of the plurality of electronic components. The isolation structure is flush with or protrudes from the board back surface and covers the welding pins of the plurality of electronic components.

According to some embodiments of the present disclosure, at least part of an inner wall of the electric control box facing towards the first side of the electric control board is formed as a profiling structure; and a configuration of a first side of the at least part of the plurality of electronic components mounted at the first side of the electric control board is defined as a first side configuration of the electric control component. The profiling structure is similar to the first side configuration of the electric control component.

According to some embodiments of the present disclosure, the electric control box comprises a first box and a second box that are formed independently. A box wall of the first box encloses to define a cavity with an opening; the box wall of the first box has a bottom wall opposite to the opening and a surrounding wall surrounding the bottom wall to form the opening. The bottom wall of the first box constitutes the profiling structure. The electric control component is fixed in the cavity of the first box. A space between the bottom wall of the first box and the first side of the electric control board constitutes the filling space.

According to some embodiments of the present disclosure, the isolation structure is a gel structure formed through potting, an opening side of the first box is configured as a potting side, and a gel material enters the filling space through the opening of the first box.

According to some embodiments of the present disclosure, a gap is formed between an outer edge of a board surface of the electric control board and the surrounding wall of the first box. At least part of the gap constitutes a potting port in communication with the filling space.

According to some embodiments of the present disclosure, the electric control board has a first potting hole formed on the electric control board. The first potting hole is in communication with the filling space.

According to some embodiments of the present disclosure, an equivalent diameter of the first potting hole is greater than 10 mm; and/or the first potting hole is located in a center portion of the electric control board.

According to some embodiments of the present disclosure, the first box is internally provided with a first fixing column supported at the first side of the electric control board and a second fixing column connected to the second box. The electric control board is mounted at the first fixing column, and a surface of the second side of the electric control board serves as a board back surface. The second fixing column is located at an outer peripheral side of the electric control board and protrudes from the board back surface.

According to some embodiments of the present disclosure, the isolation structure is a gel structure, and a potting side of the filling space is located at the first side of the electric control board. A part of the electric control box located at the first side of the electric control board has a second potting hole formed on the part of the electric control box, and the second potting hole is located at the highest level of the electric control box when the first side of the electric control board faces upwards.

According to some embodiments of the present disclosure, the isolation structure is a gel structure, the heat dissipation component is led out from a potting side of the electric control box; and/or the isolation structure is the gel structure, a wiring harness connected to the electric control component is led out from the potting side of the electric control box.

According to some embodiments of the present disclosure, the heat dissipation component comprises a heat dissipation member. The heat dissipation member comprises a heat dissipation main body located in the electric control box. The heat dissipation member internally has a heat dissipation channel to allow for flow of a heat dissipation medium.

According to some embodiments of the present disclosure, the heat dissipation component comprises a medium inlet pipe and a medium outlet pipe. The heat dissipation channel is in communication with the medium inlet pipe and the medium outlet pipe.

According to some embodiments of the present disclosure, a plurality of heat dissipation members are provided and arranged in parallel.

According to some embodiments of the present disclosure, the medium inlet pipe and the medium outlet pipe are located at two sides of the electric control board in a length direction of the electric control board. The heat dissipation member extends in the length direction of the electric control board. The plurality of heat dissipation members are arranged in a width direction of the electric control board.

According to some embodiments of the present disclosure, an inner wall of the electric control box is provided with a third limiting structure. The medium inlet pipe and the medium outlet pipe cooperate with the third limiting structure to limit positions of the medium inlet pipe and the medium outlet pipe.

According to some embodiments of the present disclosure, a part of the medium inlet pipe and a part of the medium outlet pipe are located between an outer edge of the electric control board and an inner wall of the electric control box.

According to some embodiments of the present disclosure, the heat dissipation member is a phase-change heat dissipation element and comprises a heat absorption segment and a heat dissipation segment. The heat dissipation medium in the heat dissipation member is adapted to circulate and flow between the heat absorption segment and the heat dissipation segment, and the heat absorption segment comprises the heat dissipation main body.

According to some embodiments of the present disclosure, the heat dissipation component comprises at least one heat dissipation member. The at least one heat dissipation member comprises a heat dissipation main body located in the electric control box. The heat dissipation main body of the at least one heat dissipation member covers outer peripheral sides of the plurality of electronic components.

According to some embodiments of the present disclosure, the at least one heat dissipation member comprises first heat dissipation members, each of the first heat dissipation members has a heat dissipation main body located at the outer peripheral sides of the plurality of electronic components. The heat dissipation main body of each of at least part of the first heat dissipation members extends along a non-straight line.

According to some embodiments of the present disclosure, the heat dissipation main body of the first heat dissipation member at least partially extends in a circumferential direction of the plurality of electronic components.

According to some embodiments of the present disclosure, the heat dissipation main body of the first heat dissipation member comprises a bent portion or a plurality of bent portions arranged at intervals in an extending direction of the first heat dissipation member. The bent portion or each of the plurality of bent portions comprises a plurality of bent segments sequentially connected in the extending direction of the first heat dissipation member, and an angle is formed between two adjacent bent segments of the plurality of bent segments.

According to some embodiments of the present disclosure, the angle between two adjacent bent segments of the plurality of bent segments ranges from 90° to 170°.

According to some embodiments of the present disclosure, the first heat dissipation member further comprises a non-bent portion extending along a straight line, and one of the plurality of bent segments of the bent portion connected to the non-bent portion serves as a first bent segment, an angle between the non-bent portion and the first bent segment ranging from 90° to 170°.

According to some embodiments of the present disclosure, the at least one heat dissipation member comprises a first heat dissipation member having a heat dissipation main body located at the outer peripheral sides of the plurality of electronic components.

According to some embodiments of the present disclosure, the at least one heat dissipation member comprises a first heat dissipation member having a heat dissipation main body located at the outer peripheral sides of the plurality of electronic components. At least part of the plurality of electronic components are arranged in a length direction of the electric control board to constitute an electronic component group. The heat dissipation main body of the first heat dissipation member extends in a circumferential direction of the electronic components of the electronic component group; and/or the first heat dissipation member is disposed at each of two sides of the electronic component group in a width direction of the electric control board.

According to some embodiments of the present disclosure, the at least one heat dissipation member comprises a first heat dissipation member having a heat dissipation main body located at the outer peripheral sides of the plurality of electronic components. A peripheral side surface of each of the plurality of electronic components is an electronic component side surface, and the heat dissipation main body of the first heat dissipation member is in thermally conductive connection with the electronic component side surface.

According to some embodiments of the present disclosure, the at least one heat dissipation member comprises a first heat dissipation member having a heat dissipation main body located at the outer peripheral sides of the plurality of electronic components. A plurality of heat dissipation members is provided. The plurality of heat dissipation members comprises the first heat dissipation member and a second heat dissipation member. An end surface of each of the plurality of electronic components in a height direction of the electronic component is an electronic component end surface, and the heat dissipation main body of the second heat dissipation member is in thermally conductive connection with the electronic component end surface.

According to some embodiments of the present disclosure, the heat dissipation main body of the second heat dissipation member comprises a fixing portion and a heat dissipation portion. The heat dissipation portion has a heat dissipation channel to allow for flow of a heat dissipation medium, and the fixing portion is connected to the electric control board by a fastener.

According to some embodiments of the present disclosure, a thermally conductive layer is disposed between the heat dissipation main body and the plurality of electronic components. The thermally conductive layer comprises one or more of a thermally conductive adhesive, thermally conductive silicone grease, a thermally conductive pad, and a thermally conductive metal.

According to some embodiments of the present disclosure, the heat dissipation main body is formed in a flat shape. At least one side of the heat dissipation main body in a thickness direction of the heat dissipation main body is opposite to the plurality of electronic components or is in thermally conductive connection with the plurality of electronic components.

According to some embodiments of the present disclosure, the heat dissipation component comprises at least one heat dissipation member. Each of the at least one heat dissipation member comprises a heat dissipation main body located in the electric control box. An inner wall of the electric control box is provided with a first limiting structure, and at least part of the at least one heat dissipation member is engaged with the first limiting structure to limit a position of the at least one heat dissipation member.

According to some embodiments of the present disclosure, the first limiting structure comprises a first limiting groove. The at least part of the at least one heat dissipation member is received in the first limiting groove.

According to an embodiment of a second aspect of the present disclosure, a potting method of the electric control module assembly according to the embodiment of the first aspect of the present disclosure described above comprises: assembling the electric control component and the heat dissipation component into the electric control box to form a pre-assembled assembly; adjusting the pre-assembled assembly to orient a potting side of the electric control box to face upwards; and potting gel into the electric control box from the potting side of the electric control box to form the isolation structure.

With the potting method according to the embodiment of the present disclosure, the electric control box is internally formed with the isolation structure, which can allow the electronic component to be isolated from the air, and thus prevent the condensation from being generated at the electronic components of the electric control module, improving the reliability, stability, and safety of the electric control module. In addition, when the flammable and explosive gas is present in the environment where the electric control module is located, the isolation structure is provided and encapsulates the outer surfaces of the electronic components, which can eliminate the safety hazards of the ignition and explosion caused by the contact between the flammable and explosive gas and the electronic components, while achieving the effects of improving the vibration resistance performance of the electric control module, preventing the disengagement of the electronic components, buffering and protecting the electronic components, and the dust prevention.

According to some embodiments of the present disclosure, said assembling the electric control component and the heat dissipation component into the electric control box to form the pre-assembled assembly comprises: assembling a part of the heat dissipation component to the electric control component, assembling the electric control component assembled with the heat dissipation component into a first box of the electric control box, and orienting a first side of the electric control board towards the first box, in which the first side of the electric control board is provided with the plurality of electronic components; said adjusting the pre-assembled assembly to orient the potting side of the electric control box to face upwards comprises: adjusting the pre-assembled assembly to orient a second side of the electric control board to face upwards; and said potting the gel into the electric control box from the potting side of the electric control box to form the isolation structure comprises: potting the gel into the first box from the second side of the electric control board to form the isolation structure, and assembling a second box of the electric control box to the first box.

The outdoor unit according to an embodiment of a third aspect of the present disclosure comprises: an outdoor unit casing; an outdoor heat exchanger and an outdoor fan that are disposed in the outdoor unit casing; a compressor assembly disposed in the outdoor unit casing; and the electric control module assembly according to the embodiment of the first aspect of the present disclosure described above. The electric control module assembly is disposed in the outdoor unit casing.

With the outdoor unit according to the embodiment of the present disclosure, by providing the electric control module assembly described above, a heat dissipation effect for the electric control module can be improved. The isolation structure is provided to isolate the electronic components from the air, and thus prevent the condensation from being generated at the electronic components of the electric control module, improving the reliability, stability, and safety of the electric control module. In addition, when the flammable and explosive gas is present in the environment where the electric control module is located, the isolation structure is provided and encapsulates the outer surfaces of the electronic components, which can eliminate the safety hazards of the ignition and explosion caused by the contact between the flammable and explosive gas and the electronic components, while achieving the effects of improving the vibration resistance performance of the electric control module, preventing the disengagement of the electronic components, buffering and protecting the electronic components, and the dust prevention.

According to some embodiments of the present disclosure, a refrigerant circulation system of the outdoor unit comprises a cooling portion configured to dissipate heat from the electric control module. The cooling portion is in thermally conductive connection with the heat dissipation component, or at least part of the cooling portion constitutes the heat dissipation component.

According to some embodiments of the present disclosure, the outdoor unit further comprises a water-circuit heat exchange assembly comprising a water-circuit heat exchanger. The water-circuit heat exchanger has a water flow channel and a refrigerant channel exchanging heat with each other, and the cooling portion is connected between the refrigerant channel of the water-circuit heat exchanger and the outdoor heat exchanger.

The heating, ventilation and air conditioning equipment according to an embodiment of a fourth aspect of the present disclosure comprises the outdoor unit according to the embodiment of the third aspect of the present disclosure described above.

With the heating, ventilation and air conditioning equipment according to the embodiment of the present disclosure, by providing the outdoor unit described above, the electric control module assembly of the outdoor unit is provided with the heat dissipation component, which can improve the heat dissipation effect for the electric control module. The electric control module assembly is further provided with the isolation structure, which can allow the electronic components to be isolated from the air, and thus prevent the condensation from being generated at the electronic components of the electric control module, improving the reliability, stability, and safety of the electric control module. In addition, when the flammable and explosive gas is present in the environment where the electric control module is located, the isolation structure is provided and encapsulates the outer surfaces of the electronic components, which can eliminate the safety hazards of the ignition and explosion caused by the contact between the flammable and explosive gas and the electronic components, while achieving the effects of improving the vibration resistance performance of the electric control module, preventing the disengagement of the electronic components, buffering and protecting the electronic components, and the dust prevention.

Additional aspects and advantages of the present disclosure will be provided in part in the following description, or will become apparent in part from the following description, or can be learned from practicing of the present disclosure.

### BRIEF DESCRIPTION OF the DRAWINGS

The above and/or additional aspects and advantages of the present disclosure will become more apparent and more understandable from the following description of embodiments taken in conjunction with the accompanying drawings, in which:
FIG. 1 is a schematic view of an outdoor unit according to some embodiments of the present disclosure.
FIG. 2 is a partially enlarged view of part A in FIG. 1.
FIG. 3 is a schematic view of an electric control module assembly according to some embodiments of the present disclosure.
FIG. 4 is a schematic view of the electric control module assembly in FIG. 3 from another perspective.
FIG. 5 is a schematic view showing the positional relationship between a heat dissipation component and an electric control component of the electric control module assembly in FIG. 3.
FIG. 6 is a schematic view of an electric control box of the electric control module assembly in FIG. 3.
FIG. 7 is a schematic view of a heat dissipation component of the electric control module assembly in FIG. 3.
FIG. 8 is a schematic view of an electric control module assembly according to other embodiments of the present disclosure.
FIG. 9 is a schematic view of the electric control module assembly in FIG. 8 from another perspective.
FIG. 10 is a schematic view showing the positional relationship between a heat dissipation component and an electric control component of the electric control module assembly in FIG. 8.
FIG. 11 is a schematic view of an electric control box of the electric control module assembly in FIG. 8.
FIG. 12 is a schematic view of a heat dissipation component of the electric control module assembly in FIG. 8.
FIG. 13 is a schematic view of a partial structure of an electric control module assembly according to some embodiments of the present disclosure.
FIG. 14 is a schematic view of the electric control module assembly in FIG. 13 from another perspective.
FIG. 15 is a schematic view showing the positional relationship between a heat dissipation component and an electric control component of the electric control module assembly in FIG. 13.
FIG. 16 is a schematic view showing the positional relationship between an electric control box and a heat dissipation component of the electric control module assembly in FIG. 13.
FIG. 17 is a schematic view of a heat dissipation component of the electric control module assembly in FIG. 13.
FIG. 18 is a cross-sectional schematic view of a second heat dissipation member of the heat dissipation component in FIG. 17.
FIG. 19 is a schematic view of a partial structure of an electric control module assembly according to other embodiments of the present disclosure.
FIG. 20 is a schematic view of the electric control module assembly in FIG. 19 from another perspective.
FIG. 21 is a schematic view showing the positional relationship between a heat dissipation component and an electric control component of the electric control module assembly in FIG. 19.
FIG. 22 is a schematic view showing the positional relationship between an electric control box and a heat dissipation component of the electric control module assembly in FIG. 19.
FIG. 23 is a schematic view of a heat dissipation component of the electric control module assembly in FIG. 19.
FIG. 24 is a schematic view of an outdoor unit according to other embodiments of the present disclosure.

### Reference numerals:

100, outdoor unit;
10, electric control module assembly; 11, outdoor unit casing; 12, outdoor fan; 13, compressor assembly; 14, water-circuit heat exchanger; 141, first refrigerant inlet/outlet; 142, second refrigerant inlet/outlet; 15, cooling portion;
20, electric control module; 21, electric control component; 22, electric control board; 221, first side; 222, second side; 23, electronic component; 231, electronic component end surface; 232, electronic component side surface; 24, electric control box; 241, first box; 2411, opening; 2412, cavity; 2413, surrounding wall; 2414, bottom wall; 242, second box; 25, first limiting structure; 251, first limiting groove; 26, second limiting structure; 27, third limiting structure; 28, first fixing column; 29, second fixing column;
30, heat dissipation component; 31, heat dissipation member; 31a, first heat dissipation member; 31b, second heat dissipation member; 311, fixing portion; 312, heat dissipation portion; 31c, third heat dissipation member; 31d, fourth heat dissipation member; 32, heat dissipation main body; 33, bent portion; 34, bent segment; 341, first bent segment; 35, non-bent portion; 36, heat dissipation channel; 37, medium inlet pipe; 38, medium outlet pipe;
40, straight segment; 41, connection segment; 42, heat absorption segment; 43, heat dissipation segment; 44, potting port; 45, first potting hole; 46, electronic component group; 46a, first electronic component group; 46b, second electronic component group;
50, water-circuit inlet; 51, water-circuit outlet; 52, throttling component; 53, thermally conductive substrate; 54, connection pipeline; 55, cooling bypass.

### detailed DESCRIPTION

Embodiments of the present disclosure will be described in detail below with reference to examples thereof as illustrated in the accompanying drawings, throughout which same or similar elements, or elements having same or similar functions, are denoted by same or similar reference numerals. The embodiments described below with reference to the drawings are illustrative only, and are intended to explain, rather than limiting, the present disclosure.

An electric control module assembly 10 according to the embodiments of the present disclosure is described below with reference to the accompanying drawings.

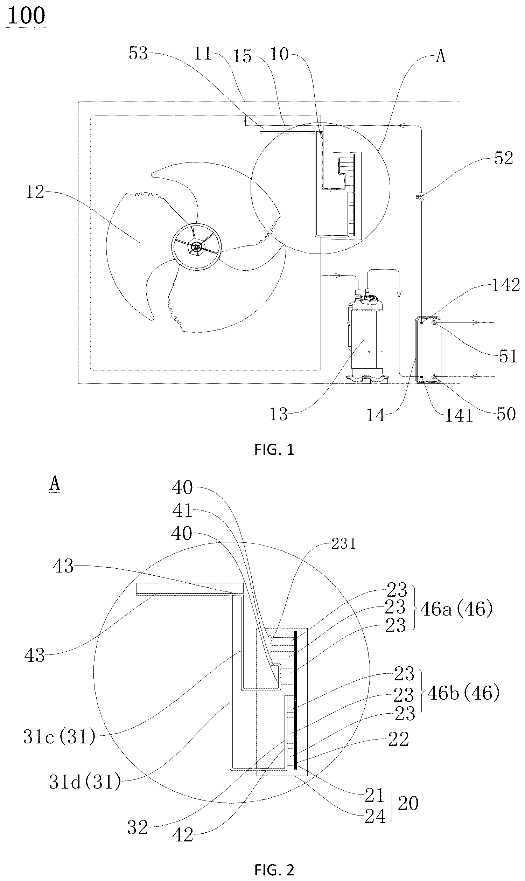

Referring to FIG. 1 to FIG. 12, the electric control module assembly 10 according to an embodiment of a first aspect of the present disclosure comprises an electric control module 20 and a heat dissipation component 30. The electric control module 20 comprises an electric control box 24 and an electric control component 21 disposed in the electric control box 24. The electric control component 21 comprises an electric control board 22 and a plurality of electronic components 23 disposed at the electric control board 22. The heat dissipation component 30 is configured to dissipate heat from the electric control module 20.

The electric control box 24 is internally provided with an isolation structure that encapsulates outer surfaces of the plurality of electronic components 23 to isolate the plurality of electronic components 23 from air.

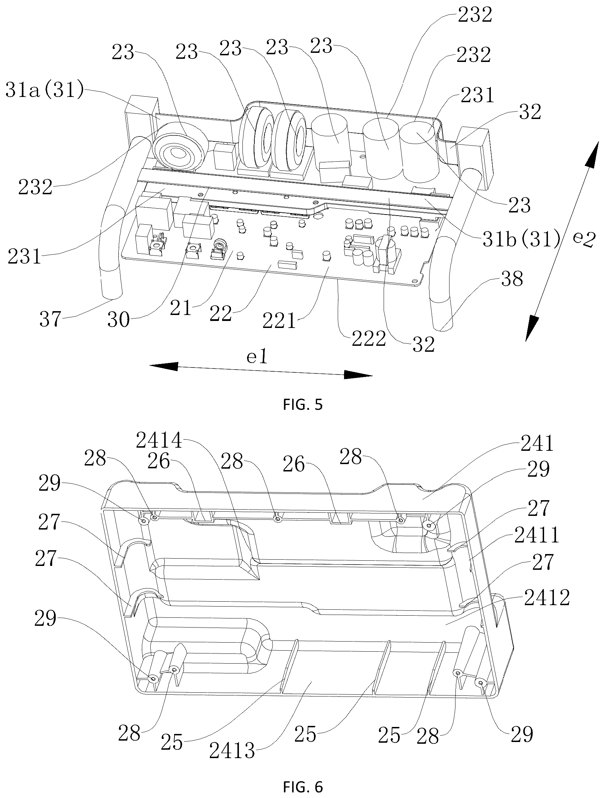

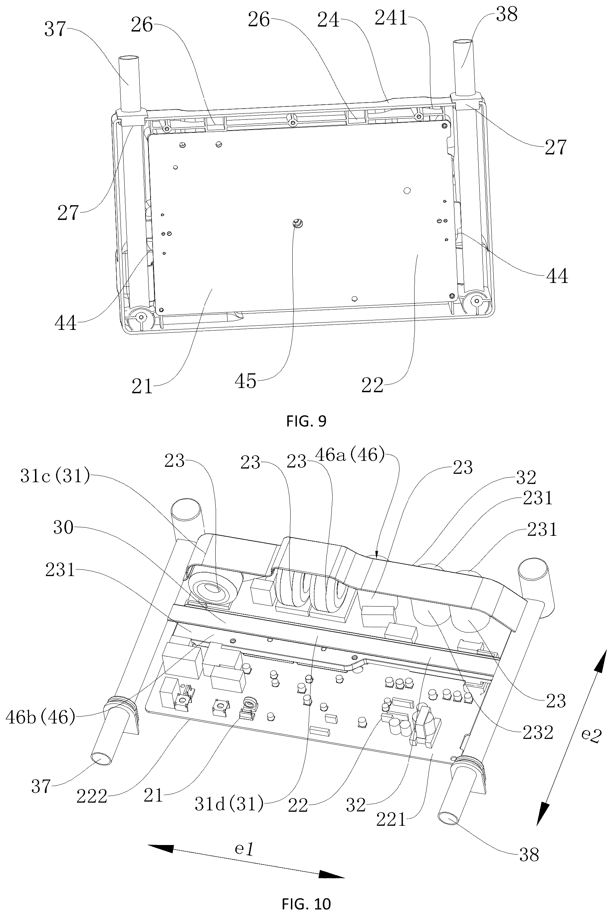

For example, referring to FIG. 5 and FIG. 10, the electric control module 20 comprises the electric control box 24 and the electric control component 21 disposed in the electric control box 24. The electric control component 21 comprises the electric control board 22 and the plurality of electronic components 23 disposed at the electric control board 22. The electric control box 24 is internally provided with the isolation structure that encapsulates the outer surfaces of the plurality of electronic components 23 to isolate the plurality of electronic component 23 from the air.

During operation of the electric control module 20, the electronic components 23 of the electric control component 21 generates heat, causing a temperature of the electric control module 20 to gradually rise. By providing the heat dissipation component 30, the heat dissipation component 30 may exchange heat with the electric control module 20 to cool the electric control module 20, controlling the temperature of the electric control module 20 to be within a normal range to ensure stable operation of the electric control module 20.

Moreover, the isolation structure is provided and encapsulates the outer surfaces of the plurality of electronic components 23 of the electric control component 21 to isolate the electronic components from the air. Therefore, during heat dissipation and cooling of the electric control module 20 by the heat dissipation component 30, the electronic components 23 do not come into contact with external air to cause a condensation phenomenon, which can prevent condensation from being generated at the electronic components 23, improve reliability, stability, and safety of the electric control module 20, and thus improve reliability, stability, and safety of the entire unit.

It should be noted that the outer surface of the electronic component 23 comprise an outer surface of a main body and/or an outer surface of a pin of the electronic component 23. That is, the outer surface of the electronic component 23 may comprise the outer surface of the main body of the electronic component 23, or the outer surface of the pin of the electronic component 23, or the outer surfaces of both the main body and the pin of the electronic component 23.

With the electric control module assembly 10 according to the embodiments of the present disclosure, by providing the heat dissipation component 30, the heat dissipation may be performed on the electric control module 20. Moreover, the isolation structure is provided and encapsulates the outer surfaces of the electronic components 23 to isolate the electronic components 23 from the air, thus preventing the condensation from being generated at the electronic components 23 of the electric control module 20, improving the reliability, stability, and safety of the electric control module 20. In addition, when flammable and explosive gas is present in an environment where the electric control module 20 is located, the isolation structure is provided and encapsulates the outer surfaces of the electronic components 23, which can eliminate safety hazards of ignition and explosion caused by contact between the flammable and explosive gas and the electronic components 23, while achieving effects of improving vibration resistance performance of the electric control module 20, preventing disengagement of the electronic components 23, buffering and protecting the electronic components 23, and dust prevention.

For example, in order to eliminate the safety hazards of the ignition and explosion caused by the contact between the flammable and explosive gas and the electronic components 23 of the electric control module 20, it is generally necessary to perform a sealing treatment on the electric control box 24. A sealing structure or a sealing member is provided to ensure sealing performance of the electric control box 24. In addition, by providing, in the electric control box 24, the isolation structure configured to encapsulating the outer surfaces of the electronic components 23, it is possible to eliminate the safety hazards of the ignition and explosion caused by the contact between the flammable and explosive gas and the electronic components 23, while reducing a requirement for the sealing performance of the electric control box 24, decreasing an arrangement of parts such as the sealing member, lowering production and processing difficulty to some extent, and reducing costs.

For example, the electric control module 20 may be an electric control module 20 of an outdoor unit 100. When a refrigerant circulation system of the outdoor unit 100 adopts a flammable refrigerant, and the refrigerant circulation system fails and causes refrigerant leakage, the flammable and explosive gas will be present in the environment where the electric control module 20 is located, and the electronic components 23 of the electric control module 20 occurs safety hazards of ignition and explosion caused by its contact with the flammable and explosive gas. The isolation structure is provided in the electric control box 24 and encapsulates the outer surfaces of the electronic components 23, which can allow the outer surfaces of the electronic components 23 to be isolated from the air, eliminating the safety hazards of the ignition and explosion, while achieving the effects of improving the vibration resistance performance of the electric control module 20, preventing the disengagement of the electronic components 23, buffering and protecting the electronic components 23, and the dust prevention.

It should be noted that "a plurality of" in the present disclosure refers to two or more.

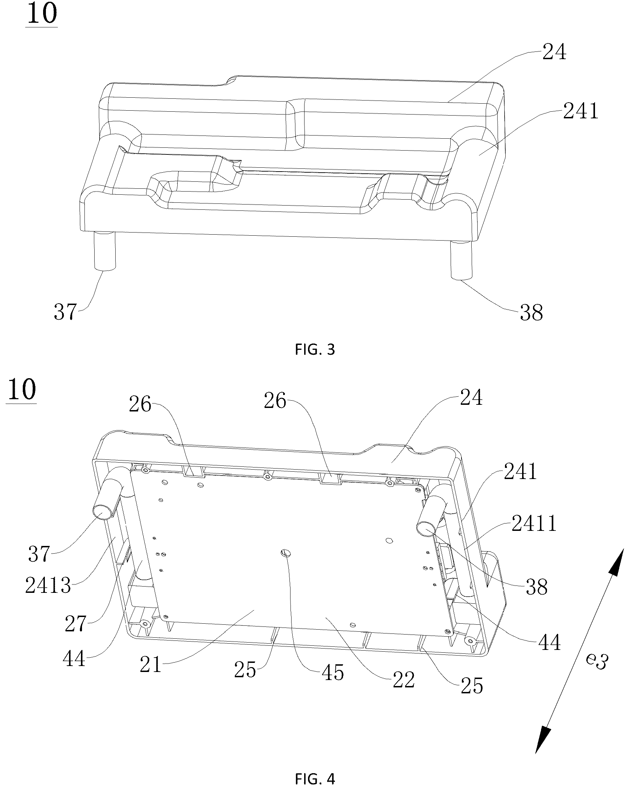

Referring to FIG. 3 to FIG. 12, according to some embodiments of the present disclosure, the isolation structure is a gel structure. A potting gel adopted in the gel structure has fluidity before its solidification, and thus may be fully in contact with the outer surfaces of the electronic components 23, which enables an isolation structure formed after the potting to better encapsulate the outer surfaces of the electronic components 23, and can ensure an effect of isolating the electronic component 23 from the air, making the electronic component 23 better isolated from the air, and preventing the condensation phenomenon from occurring at the electronic components 23 due to cooling. In addition, the gel structure can improve an overall structural strength of the electric control module assembly 10, improve the vibration resistance performance, and play a role in buffering and protecting the electronic components 23.

Referring to FIG. 3 to FIG. 12, according to some embodiments of the present disclosure, a part of the heat dissipation component 30 is located in the electric control box 24 and is in thermally conductive connection with the electric control component 21; and a space defined by the electric control box 24, the electric control component 21, and the heat dissipation component 30 is filled with the isolation structure. The electric control component 21 and the part of the heat dissipation component 30 are connected into one piece by the isolation structure. The isolation structure can integrate the electric control component 21 with the heat dissipation component 30. In addition, the isolation structure may further be provided outside the space defined by the electric control box 24, the electric control component 21, and the heat dissipation component 30 to ensure an encapsulating effect of the isolation structure on the outer surfaces of the electronic components 23. The part of the heat dissipation component 30 is in thermally conductive connection with the electric control component 21. Heat generated by the electric control component 21 during operation may be transferred to the heat dissipation component 30. In this way, a heat dissipation function of the heat dissipation component 30 for the electric control component 21 can be realized, a temperature of the electric control component 21 can be reduced, and the stability of the operation of the electric control module 20 can be ensured. The electric control component 21 and the heat dissipation component 30 are connected into one piece by the isolation structure. Through this arrangement, a fixing effect of the isolation structure on the electric control component 21 and the heat dissipation component 30 can be realized, and an overall structural strength of the electric control module assembly 10 can be improved. Meanwhile, the heat dissipation component 30 integrally connected to the electric control component 21 has a better heat dissipation effect.

Referring to FIG. 4 to FIG. 6 and FIG. 9 to FIG. 11, according to some embodiments of the present disclosure, an inner wall of the electric control box 24 or the electric control board 22 is provided with a first limiting structure 25 configured to limit a position of the part of the heat dissipation component 30. Through this arrangement, a position limiting effect of the electric control box 24 on the heat dissipation component 30 can be realized, stability of a position of the heat dissipation component 30 can be ensured, and thus a heat dissipation effect of the heat dissipation component 30 on the electric control component 21 can be ensured.

For example, referring to FIG. 6, three limiting protrusions are formed at three different positions of the inner wall of the electric control box 24. Each of the three limiting protrusions serves as the first limiting structure 25. The heat dissipation component 30 may be provided with a limiting notch engaged with each of the three limiting protrusions at the inner wall. A position limiting effect of the first limiting structure 25 on the heat dissipation component 30 is realized through the engagement between the limiting protrusions at the inner wall and the limiting notches. In addition, through this arrangement, assembly of the heat dissipation component 30 and the electric control box 24 can be facilitated.

Referring to FIG. 4 to FIG. 7 and FIG. 10 to FIG. 12, according to some embodiments of the present disclosure, the electric control board 22 has a first side 221 and a second side 222 opposite to each other in a thickness direction of the electric control board 22. A filling space is defined between the first side 221 of the electric control board 22 and the electric control box 24. At least part of the plurality of electronic components 23 is disposed at the first side 221 of the electric control board 22 and located in the filling space, and the filling space is filled with the isolation structure. The at least part of the electronic components 23 are disposed at the first side 221 of the electric control board 22 and located in the filling space, i.e., the electronic components 23 may be partially or entirely disposed at the first side 221 of the electric control board 22 and located in the filling space.

The isolation structure is provided in the filling space, which can ensure an isolation effect of the isolation structure on the electronic components 23, preventing the generation of condensation caused by contact between the electronic components 23 and external air. In addition, the electronic components 23 are each located at the first side 221 of the electric control board 22, which can facilitate a potting operation for the filling space, while reducing used material of the isolation structure.

Referring to FIG. 3 to FIG. 12, according to some embodiments of the present disclosure, a part of the heat dissipation component 30 is located in the filling space and is in thermally conductive connection with the plurality of electronic components 23. The heat dissipation component 30 and the electronic components 23 may be thermally connected in various ways. For example, the heat dissipation component 30 located inside the filling space may be directly thermally connected to the electronic components 23. Alternatively, a thermally conductive layer may be disposed between the heat dissipation component 30 and the outer surfaces of the electronic components 23 to realize a thermally conductive connection between the heat dissipation component 30 and the electronic components 23 through the thermally conductive layer. The heat dissipation component 30 is in thermally conductive connection with the electronic components 23, which can ensure a heat dissipation effect of the heat dissipation component 30 located in the filling space on the electronic components 23 also located in the filling space. Meanwhile, the isolation structure in the filling space may allow the heat dissipation component 30 and the electronic components 23 located in the filling space to be isolated from the external air, preventing the condensation phenomenon from occurring during the heat dissipation.

Referring to FIG. 3 to FIG. 12, according to some embodiments of the present disclosure, the isolation structure is filled between an outer edge of the electric control board 22 and an inner wall of the electric control box 24. By filling the isolation structure, the external air can be prevented from entering the electric control component 21 through a gap between the outer edge of the electric control board 22 and the inner wall of the electric control box 24, which can ensure the isolation effect of the isolation structure on the electronic components 23 and thus better prevent the condensation from being generated at the electronic components 23 during the heat dissipation.

Referring to FIG. 3 to FIG. 12, according to some embodiments of the present disclosure, the plurality of electronic components 23 may be mounted at the first side 221 of the electric control board 22. A surface of the second side 222 of the electric control board 22 serves as a board back surface. The board back surface of the electric control board 22 exposes welding pins of the plurality of electronic components 23. The isolation structure is flush with or protrudes from the board back surface and covers the welding pins of the plurality of electronic components 23 located at the board back surface. The isolation structure is flush with the board back surface, which can ensure the isolation effect of the isolation structure on the electronic components 23 disposed at the electric control board 22, preventing the electronic components 23 from being in contact with the external air and generating condensation during the heat dissipation. The isolation structure protrudes from and covers the board back surface. Through this arrangement, the isolation effect of the isolation structure on the electronic component 23 can be ensured, while the board back surface of the electric control board 22 can be isolated from the air through the isolation structure, preventing the condensation from being generated at the back surface of the electric control board 22. For example, through this arrangement, the welding pins of the plurality of electronic components 23 located at the board back surface may also be encapsulated in the isolation structure, preventing the pins from being in contact with the external air and generating condensation during heat dissipation. Meanwhile, when the electronic components are also disposed at the board back surface, the isolation structure protrudes from and covers the board back surface, which can ensure the isolation effect of the isolation structure on the electronic components 23 disposed at the electric control board 22, improve the overall structural strength, and achieve a good effect of buffering and protecting the electronic component 23.

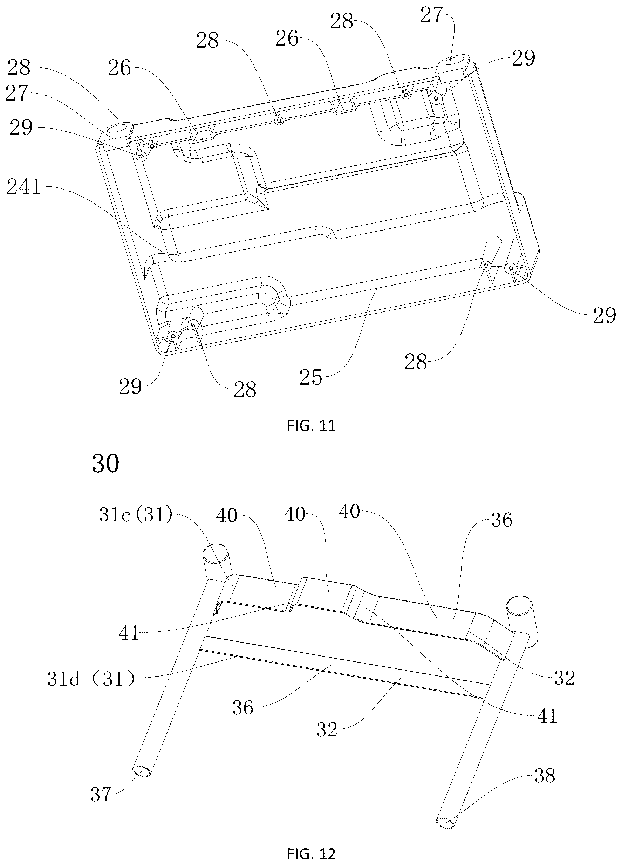

Referring to FIG. 6 and FIG. 11, according to some embodiments of the present disclosure, at least part of an inner wall of the electric control box 24 facing towards the first side 221 of the electric control board 22 is formed as a profiling structure; and a configuration of a first side of the at least part of the plurality of electronic components 23 mounted at the first side 221 of the electric control board 22 is defined as a first side configuration of the electric control component 21. The profiling structure has a shape similar to that of the first side configuration of the electric control component 21. By providing the profiling structure, a space occupancy rate of the filling space can be reduced to a greater extent, and a space utilization rate inside the electric control module assembly 10 can be improved. Meanwhile, through this arrangement, the used materials of the isolation structure can be reduced, and a production cost can be reduced to some extent.

The at least part of the inner wall of the electric control box 24 facing towards the first side 221 of the electric control board 22 is formed as the profiling structure, i.e., the inner wall of the electric control box 24 facing towards the first side 221 of the electric control board 22 may be partially or entirely formed as the profiling structure to reduce the used materials of the isolation structure and reduce the production cost.

Referring to FIG. 3 to FIG. 12, according to some embodiments of the present disclosure, the isolation structure is a gel structure formed through potting, and a potting side of the filling space is located at the second side 222 of the electric control board 22. By setting the second side 222 of the electric control board 22 as the potting side, during a process of potting the gel into the filling space, an orientation of the electric control box 24 is adjusted to orient the second side 222 of the electric control board 22 to face upwards. The potting gel is potted into the filling space from the second side 222 of the electric control board 22. The potting gel flows from top to bottom under the action of gravity to flow from the second side 222 of the electric control board 22 to a lowest part of the filling space until the entire filling space is filled, and thus may encapsulate the outer surfaces of the plurality of electronic components 23 located inside the filling space, which allows the electronic components 23 to be isolated from the air and prevents the condensation from being generated at the electronic component 23 due to cooling.

Referring to FIG. 3 to FIG. 12, according to some embodiments of the present disclosure, the electric control box 24 comprises a first box 241 and a second box 242 that are formed independently. A box wall of the first box 241 encloses to define a cavity 2412 with an opening 2411. The box wall of the first box 241 has a bottom wall 2414 opposite to the opening 2411 and a surrounding wall 2413 surrounding the bottom wall 241. The surrounding wall 2413 surrounds the bottom wall 2414 of the first box 241 to form the opening 2411, and the bottom wall 2414 of the first box 241 constitutes the profiling structure. The electric control component 21 is fixed in the cavity of the first box 241. A space between the bottom wall 2414 of the first box 241 and the first side 221 of the electric control board 22 constitutes the filling space. Through this arrangement, after an operation of potting the gel into the filling space through the second side 222 of the electric control board 22 is completed, the electric control box 24 is formed by connecting the second box 242 and the first box 241, which has a reasonable structure and is simple to operate.

In addition, after the first box 241 and the second box 242 are connected, a direction of the second box 242 can be adjusted, which makes the second side 222 of the electric control board 22 face upwards. The gel is potted into the filling space through the second box 242. The potting gel flows from top to bottom under the action of gravity to flow from a side of the second box 242 to the lowest part of the filling space until the entire filling space is filled, which is simple to operate and has a good sealing effect. For example, a potting hole may be formed at the second box 242 and be in communication with the filling space to facilitate the potting operation.

Referring to FIG. 3 to FIG. 12, according to some embodiments of the present disclosure, the isolation structure is a gel structure formed through potting, an opening side of the first box 241 is configured as a potting side, the opening 2411 of the first box 241 is located at the second side 222 of the electric control board 22, and a gel material enters the filling space from the opening 2411 of the first box 241. During a process of potting the gel into the first box 241 to form the gel structure, the potting operation may be performed from the opening side of the first box 241 to make the gel material enter the filling space. For example, the gel material may enter the filling space through a gap between the outer edge of the electric control board 22 and the surrounding wall 2413 of the first box 241, or through the potting hole at the electric control board 22. After the potting is completed and the gel material is cured into the gel structure, the second box and the first box are connected and fixed.

Referring to FIG. 3 to FIG. 12, according to some embodiments of the present disclosure, a gap is formed between an outer edge of a board surface of the electric control board 22 and the surrounding wall 2413 of the first box 241. At least part of the gap constitutes a potting port 44 in communication with the filling space. The gap is formed between the outer edge of the board surface of the electric control board 22 and the surrounding wall 2413 of the first box 241, and the at least part of the gap constitutes the potting port 44, i.e., the gap may partially or entirely constitute the potting port 44. By forming the potting port 44, the potting operation may be performed through the potting port 44 at the gap between the outer edge of the board surface of the electric control board 22 and the surrounding wall 2413 of the first box 241. Through this arrangement, the potting port 44 is allowed to have a simple structure and to facilitate the potting operation.

After the electric control board 22 and the heat dissipation component 30 are assembled, the electric control board 22 and the heat dissipation component 30 are inverted and installed into the first box 241 and assembled with the first box 241. Then, an orientation of the first box 241 is adjusted to orient the second side 222 of the electric control board 22 to face upwards. Moreover, the gel is potted into the filling space through the potting port 44 at the second side 222 of the electric control board 22. The potting gel flows from top to bottom under the action of gravity to flow from the second side 222 of the electric control board 22 to the lowest part of the filling space until the entire filling space is filled, and thus may encapsulate the outer surfaces of the plurality of electronic components 23 located inside the filling space, allowing the electronic components 23 to be isolated from the air. By potting the gel into the filling space through the potting port 44, potting efficiency can be improved to some extent while being simple to operate. In addition, the occurrence of overflow caused by excessive potting gel is avoided by observing a potting situation through the potting port 44.

Referring to FIG. 4 and FIG. 9, according to some embodiments of the present disclosure, the electric control board 22 has a first potting hole 45 formed thereon. The first potting hole 45 is in communication with the filling space. By forming the first potting hole 45, when the potting operation is performed, the gel may be potted into the filling space through the first potting hole 45 at the second side 222 of the electric control board 22, which has a simple structure and is convenient to operate. Meanwhile, the first potting hole 45 may also be used as an observation port. The potting situation in the filling space may be observed through the first potting hole 45 when the potting operation is performed.

After the electric control board 22 and the heat dissipation component 30 are assembled, the electric control board 22 and the heat dissipation component 30 are inverted and installed into the first box 241 and assembled with the first box 241. The orientation of the first box 241 is adjusted to orient the second side 222 of the electric control board 22 to face upwards. Moreover, the gel is potted into the filling space through the first potting hole 45 at the second side 222 of the electric control board 22. The potting gel flows from top to bottom under the action of gravity to flow from the second side 222 of the electric control board 22 to the lowest part of the filling space until the entire filling space is filled, and thus may encapsulate the outer surfaces of the plurality of electronic components 23 located inside the filling space, allowing the electronic component 23 to be isolated from the air. By potting the gel into the filling space through the first potting hole 45, while being simple to operate, the occurrence of the overflow caused by the excessive potting gel is avoided by observing the potting situation through the first potting hole 45.

For example, referring to FIG. 4 and FIG. 9, during a process of potting the gel into the filling space from the second side 222 of the electric control board 22, the gel may be potted into the filling space through a potting port 44 formed by a gap between the electric control board 22 and the inner wall of the first box 241, or through the first potting hole 45 at the electric control board 22, or through both the potting port 44 and the first potting hole 45.

Referring to FIG. 4 and FIG. 9, according to some embodiments of the present disclosure, an equivalent diameter of the first potting hole 45 is greater than 10 mm. Through this arrangement, it can be ensured that when the potting operation is performed through the first potting hole 45, the potting gel can flow smoothly into the filling space through the first potting hole 45, providing a sufficient operating space for the potting process. Meanwhile, the equivalent diameter of the first potting hole 45 is greater than 10 mm, which enables the first potting hole 45 to serve as an observation port. When the potting operation is performed, the potting situation inside the filling space may be observed through the first potting hole 45. In addition, through this arrangement, the potting efficiency can be improved to some extent.

Referring to FIG. 4 and FIG. 9, the first potting hole 45 is located in a center portion of the electric control board 22. Through this arrangement, the potting gel may enter the filling space from the center portion of the electric control board 22, which enables a reasonable flow path of the potting gel, thus enabling the potting gel potted into the filling space to fill the filling space more uniformly, thereby better encapsulating the electronic components 23 located in the filling space by the isolation structure formed after potting.

Referring to FIG. 6 and FIG. 11, according to some embodiments of the present disclosure, the inner wall of the first box 241 is formed with a second limiting structure 26 configured to limit a position of the electric control board 22 and a first fixing column 28 configured to fix the electric control board 22. During the assembly of the electric control board 22 with the first box 241, through the second limiting structure 26, positioning of the electric control board 22 and the first box 241 can be facilitated. After the positioning is completed, the electric control board 22 and the first box 241 may be connected and fixed through the first fixing column 28, and the assembly process is simple. Meanwhile, stability of the position of the electric control board 22 can be ensured, facilitating the potting operation.

For example, referring to FIG. 6 and FIG. 11, two limiting protrusions are formed at an edge of an inner wall of the first box 241. Each of the two limiting protrusions serves as the second limiting structure 26. A limiting notch engaged with each of the two limiting protrusions may be provided at corresponding positions of an edge of the electric control board 22. A position limiting effect of the second limiting structure 26 on the electric control board 22 is realized through the engagement between the limiting protrusions and the limiting notches. In addition, through this arrangement, assembly of the electric control board 22 and the electric control box 24 can be facilitated.

For example, referring to FIG. 6 and FIG. 11, five first fixing columns 28 are formed at an edge of the electric control box 24. After the electric control board 22 and the electric control box 24 are positioned, the electric control board 22 and the electric control box 24 are connected and fixed through the five first fixing columns 28. The first fixing columns 28 may allow the electric control board 22 to be connected to the electric control box 24 at five different positions, which can ensure a connection between the electric control board 22 and the electric control box 24 while making the connection process relatively simple. In some embodiments, the connection and fixation between the electric control box 24 and the electric control board 22 may be completed through an engagement between fasteners and the first fixing columns 28.

Referring to FIG. 4 to FIG. 6 and FIG. 9 to FIG. 11, according to some embodiments of the present disclosure, the first box 241 is internally provided with a first fixing column 28 supported at the first side 221 of the electric control board 22 and a second fixing column 28 connected to the second box 242. The electric control board 22 is mounted at the first fixing column 25, and a surface of the second side 222 of the electric control board 22 serves as a board back surface. The second fixing column 29 is located at an outer peripheral side of the electric control board 22 and protrudes from the board back surface. Through this arrangement, the first box 241 and the second box 242 may be connected and fixed through the second fixing column 29 to form the electric control box 24, which has a simple connection process and a good connection effect.

After the electric control board 22 and the heat dissipation component 30 are assembled, the electric control board 22 and the heat dissipation component 30 are inverted and installed into the first box 241 and assembled with the first box 241. Then, the orientation of the first box 241 is adjusted to orient the second side 222 of the electric control board 22 to face upwards, and the gel is potted into the filling space from the second side 222 of the electric control board 22. The second fixing column 29 is disposed at the outer peripheral side of the electric control board 22 and protrudes from the board back surface, which can prevent the potting gel from blocking the second fixing column 29 during potting, ensuring a connection effect of the second fixing column 29.

For example, referring to FIG. 6 and FIG. 11, four second fixing columns 29 are provided at four different positions of the inner wall of the first box 241. The four fixing columns enable the first box 241 and the second box 242 to be connected and fixed at the four different positions, ensuring the connection effect. In some embodiments, the connection and fixation between the first box 241 and the second box 242 may be achieved through engagement between the fasteners and the second fixing columns 29.

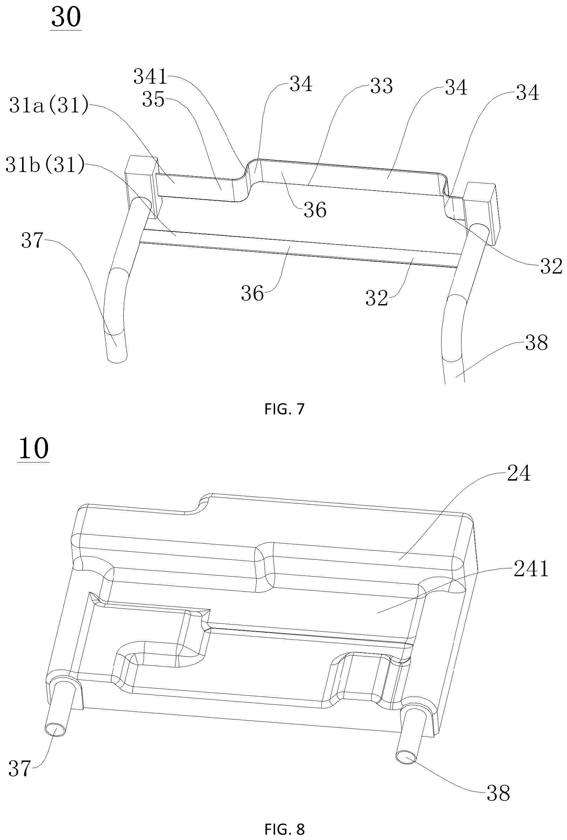

Referring to FIG. 3 and FIG. 8, according to some embodiments of the present disclosure, the isolation structure is a gel structure, and a potting side of the filling space is located at the first side 221 of the electric control board 22. A part of the electric control box 24 located at the first side 221 of the electric control board 22 has a second potting hole formed on the part of the electric control box. The second potting hole is located at the highest level of the electric control box 24 when the first side 221 of the electric control board 22 faces upwards. Through this arrangement, after the electric control board 22 and the heat dissipation component 30 are assembled, the electric control board 22 and the heat dissipation component 30 are inverted and installed into the first box 241 and assembled with the first box 241. Then, an orientation of the first box 241 is adjusted to orient the first side 221 of the electric control board 22 to face upwards. Moreover, the gel is potted into the filling space through the second potting hole located at the electric control box 24. The potting gel may flow from the highest level of the electric control box 24 to the filling space until the entire filling space is completely filled. When the potting is performed in this manner, the first side 221 of the electric control board 22 serves as the potting side. Through this arrangement, while ensuring a relatively reasonable flow path of the potting gel, it can be ensured that the potting gel may fill the entire filling space, ensuring that all the electronic components 23 in the filling space are encapsulated by the isolation structure formed after potting, and ensuring the isolation effect of the isolation structure.

Referring to FIG. 3 to FIG. 12, according to some embodiments of the present disclosure, the isolation structure is a gel structure. The heat dissipation component 30 is led out from a potting side of the electric control box 24. In response to the heat dissipation component 30 being led out from a position other than the potting side of the electric control box 24, a corresponding through hole needs to be formed at a position where the heat dissipation component 30 is led out from the box body. During the potting, the through hole may cause the occurrence of gel leakage. For example, in response to the heat dissipation component 30 being led out from a side wall of the electric control box 24, a through hole needs to be formed at a corresponding position of the side wall, and a gel leakage phenomenon easily occurs at the through hole during the potting. The heat dissipation component 30 is led out from the electric control box 24, which can make a lead-out part of the heat dissipation component 30 higher than the potting side of the electric control box 24. Moreover, the occurrence of the gel leakage during the potting can be avoided or reduced regardless of whether a through hole for leading out the heat dissipation component 30 is formed, which has a reasonable structure and can facilitate execution of the potting operation at the potting side.

Referring to FIG. 3 to FIG. 12, according to some embodiments of the present disclosure, the isolation structure is a gel structure. A wiring harness connected to the electric control component 21 is led out from the potting side of the electric control box 24. In response to the wiring harness being led out from a position other than the potting side of the electric control box 24, a corresponding through hole needs to be formed at the position where the wiring harness is led out from the box body. During the potting, the through hole may cause the occurrence of gel leakage. For example, in response to the wiring harness being led out from the side wall of the electric control box 24, a through hole needs to be formed at a corresponding position of the side wall, and the gel leakage phenomenon easily occurs at the through hole during the potting. The wiring harness is led out from the electric control box 24, which can make a lead-out part of the wiring harness higher than the potting side of the electric control box 24. Moreover, the occurrence of the gel leakage during the potting can be avoided or reduced regardless of whether the through hole for leading out the heat dissipation component 30 is formed, which has a reasonable structure and can facilitate the execution of the potting operation at the potting side.

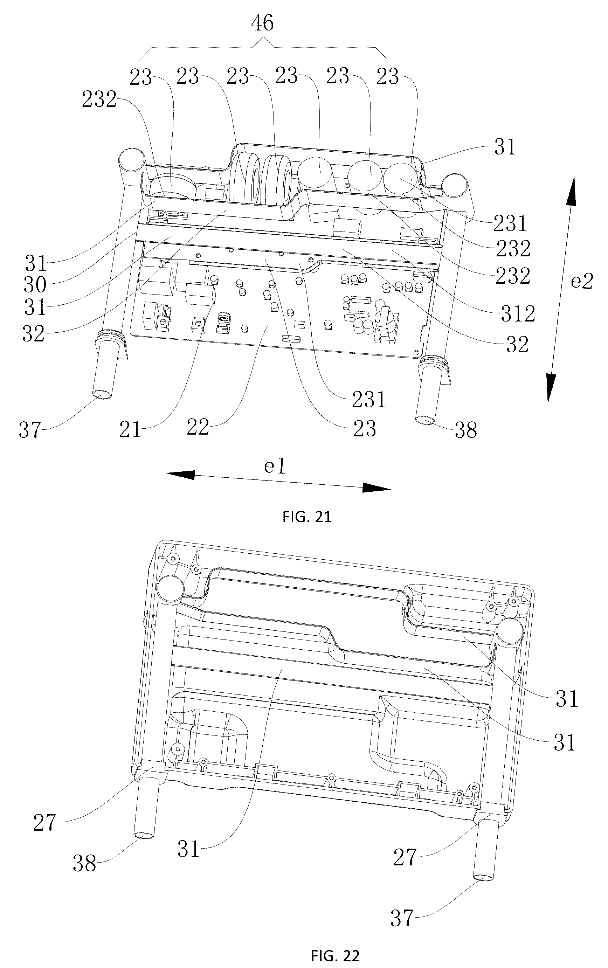

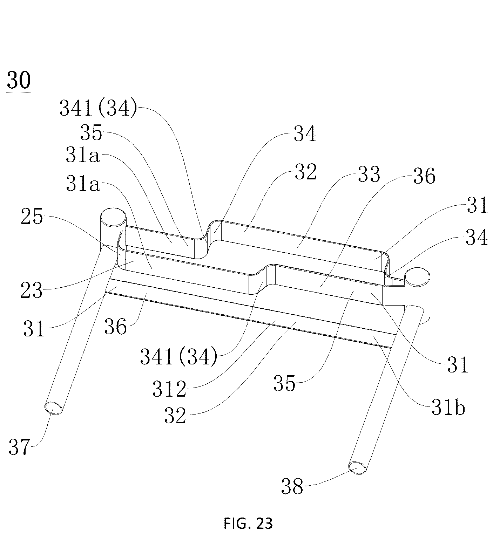

According to some embodiments of the present disclosure, referring to FIG. 3 to FIG. 7 and FIG. 13 to FIG. 23, the heat dissipation component 30 comprises at least one heat dissipation member 31. The at least one heat dissipation member 31 comprises a heat dissipation main body 32. The heat dissipation main body 32 of the at least one heat dissipation member 31 covers the outer peripheral sides of the plurality of electronic components 23. Since an area of the outer peripheral sides of the electronic components 23 is relatively large, a heat transfer area between the electronic components 23 and the heat dissipation component 30 can be increased, the heat dissipation effect on the electronic component 23 can be improved, and thus an overall heat dissipation effect for the electric control module 20 can be improved. In addition, the heat dissipation main body 32 of the at least one heat dissipation member 31 is disposed at the outer peripheral sides of the electronic components 23, which can fully utilize a space at the outer peripheral sides of the electronic components 23, and make arrangement of the heat dissipation component 30 and the electronic components 23 more compact, making a structure of the electric control module assembly 10 more compact, and making it beneficial to a reduction in a volume of the electric control module assembly 10.

The heat dissipation component 30 is configured to dissipate heat from the electric control module 20 and comprises the at least one heat dissipation member 31, i.e., the heat dissipation component 30 may comprise a heat dissipation member 31 or a plurality of heat dissipation members 31, to ensure a heat dissipation effect of the heat dissipation component 30 on the electric control module 20.

The heat dissipation main body 32 of the at least one heat dissipation member 31 is located at the outer peripheral sides of the electronic components 23, i.e., the heat dissipation main body 32 of one heat dissipation member 31 or the heat dissipation main bodies 32 of the plurality of heat dissipation members 31 may be located at the outer peripheral sides of the electronic components 23, to ensure the heat dissipation effect of the heat dissipation component 30 on the electric control module 20.

In some embodiments, a predetermined gap may be formed between the heat dissipation member 31 located at the outer peripheral sides of the electronic components 23 and the electronic components 23 to maintain a safe distance between the heat dissipation member 31 and the electronic components 23. The electronic components 23 may exchange heat with the heat dissipation main body 32 of the heat dissipation member 31 disposed at the outer peripheral sides through thermal radiation, controlling the temperature of the electronic components 23 within a normal operating temperature range.

In some embodiments, the heat dissipation member 31 located at the outer peripheral sides of the electronic components 23 may be in direct contact with the electronic components 23. The electronic components 23 are directly thermally connected to the heat dissipation main body 32 of the heat dissipation member 31 disposed at the outer peripheral sides, and exchanges heat with it, controlling the temperature of the electronic components 23 within the normal operating temperature range.

In some embodiments, the thermally conductive layer may be disposed between the heat dissipation member 31 (i.e., the heat dissipation main body 32) located at the outer peripheral sides of the electronic components 23 and the electronic components 23 to achieve thermal connection between the heat dissipation member 31 and the electronic component 23 through the thermally conductive layer. The thermally conductive layer may also achieve an effect of insulation protection. For example, the thermally conductive layer may be made of any material that is both thermally conductive and insulating, such as a thermally conductive adhesive, thermally conductive silicone grease, or a thermally conductive pad, which can achieve the effect of insulation protection while ensuring a heat transfer effect between the electronic components 23 and the heat dissipation member 31. Further, each of two sides of the thermally conductive layer is adhesive, to adhere the electronic components 23 and the heat dissipation main body 32, which is beneficial to thermal connection stability.

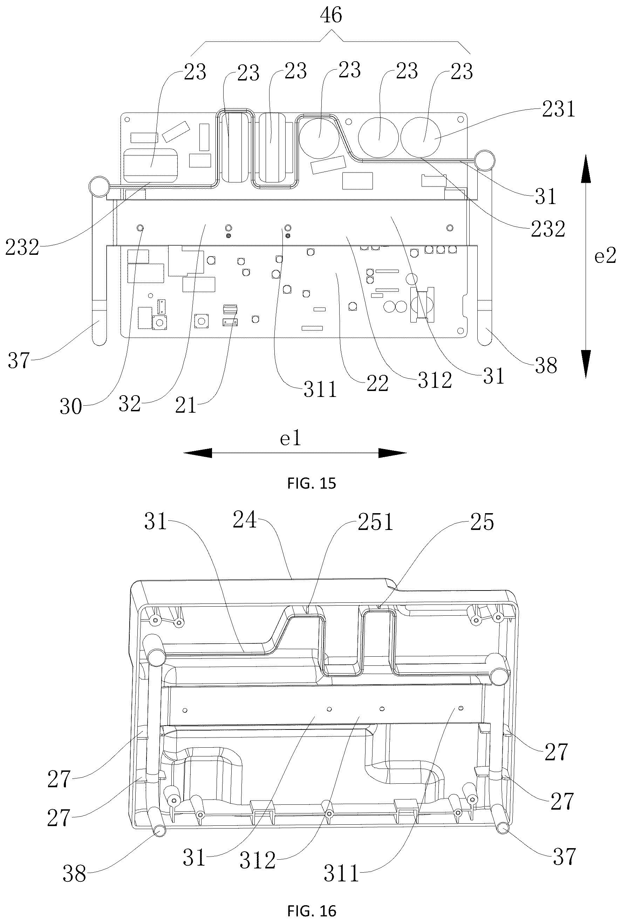

According to some embodiments of the present disclosure, referring to FIG. 15 to FIG. 17 and FIG. 21 to FIG. 23, the at least one heat dissipation member 31 comprises first heat dissipation members 31a, each of the first heat dissipation members has a heat dissipation main body 32 located at the outer peripheral sides of the plurality of electronic components 23. The heat dissipation main body 32 of each of at least part of the first heat dissipation members 31a extends along a non-straight line. For example, the heat dissipation main body 32 of each of a part of the first heat dissipation members 31a may extend along a non-straight line, or the heat dissipation main body 32 of each first heat dissipation member 31a may extend along a non-straight line. By providing the first heat dissipation member 31a extending in a circumferential direction of the electronic components 23, a heat transfer area between the heat dissipation main body 32 of the first heat dissipation member 31a and the electronic components 23 can be increased, heat dissipation efficiency of the first heat dissipation member 31a can be improved to some extent, and thus a heat dissipation effect of the first heat dissipation member 31a on the electronic components 23 can be ensured. In addition, when there are a large number of electronic components 23 in the electric control module 20, the heat dissipation member 31 extending along a non-straight line may better match the electronic components 23 arranged in the electric control module 20, which can fully utilize an internal space of the electric control module assembly 10, making the arrangement of the heat dissipation component 30 and the electronic components 23 more compact.

According to some embodiments of the present disclosure, referring to FIG. 15 to FIG. 17 and FIG. 21 to FIG. 23, the heat dissipation main body 32 of the first heat dissipation member 31a at least partially extends in a circumferential direction of the plurality of electronic components 23. The heat dissipation main body 32 of the first heat dissipation member 31a at least partially extends in the circumferential direction of the electronic components 23, i.e., the heat dissipation main body 32 of the first heat dissipation member 31a may partially or entirely extend in the circumferential direction of the electronic components 23. Through this arrangement, the first heat dissipation member 31a extending in the circumferential direction of the electronic components 23 may increase the heat transfer area between the heat dissipation main body 32 of the first heat dissipation member 31a and the electronic components 23, improve the heat dissipation efficiency of the first heat dissipation member 31a to some extent, and thus ensure the heat dissipation effect of the first heat dissipation member 31a on the electronic components 23.

It should be explained that a height of each of the electronic components 23 refers to a protruding height dimension of the electronic component 23 from the electric control board 22, and the circumferential direction of the electronic components 23 refers to a direction perpendicular to a height direction of the electronic components 23.

According to some embodiments of the present disclosure, referring to FIG. 15 to FIG. 17 and FIG. 21 to FIG. 23, the heat dissipation main body 32 of the first heat dissipation member 31a comprises a bent portion 33 or a plurality of bent portions 33 arranged at intervals in an extending direction of the first heat dissipation member 31a. The bent portion 33 or each of the plurality of bent portions 33 comprises a plurality of bent segments 34 sequentially connected in the extending direction of the first heat dissipation member 31a, and an angle is formed between two adjacent bent segments 34 of the plurality of bent segments 34. The first heat dissipation member 31a is provided with the bent portion 33, which can increase the heat transfer area between the heat dissipation main body 32 and the electronic components 23, and thus ensure the heat dissipation effect of the heat dissipation main body 32 on the electronic components 23. The bent segments 34 are sequentially connected in the extending direction of the first heat dissipation member 31a to form the bent portion 33, which has a relatively simple structure and can facilitate processing and manufacturing of the bent portion 33 to some extent.

It should be explained that in response to each of two adjacent bent segments 34 being of a straight structure, the angle between two adjacent bent segments 34 refers to an angle between straight lines where two straight structures are located. In response to at least part of each of the two bent segments 34 comprises an arc structure, the angle between two adjacent bent segments refers to an angle between a tangent line at any point of an arc structure of one of the two bent segments 34 and a tangent line at any point of an arc structure of another one of the two bent segments 34. In response to one of the two bent segments 34 being of a straight structure, and at least part of the other one of the two bent segments 34 comprising the arc structure, the angle between two adjacent bent segments 34 refers to an angle between the straight line where the straight structure is located and the tangent line at any point of the arc structure of the other one of the two bent segments 34.

For example, the first heat dissipation member 31a comprises three bent portions 33 arranged at intervals in the extending direction of the first heat dissipation member 31a. Through this arrangement, the heat dissipation effect of the heat dissipation main body 32 on the electronic components 23 can be improved.

For example, the bent portion 33 comprises three bent segments 34 connected sequentially in the extending direction of the first heat dissipation member 31a, and an angle is formed between two adjacent bent segments 34. Through this arrangement, a structure of the bent portion 33 can be made relatively simple, facilitating production and processing.

According to some embodiments of the present disclosure, referring to FIG. 15 to FIG. 17 and FIG. 21 to FIG. 23, the angle between two adjacent bent segments 34 of the plurality of bent segments 34 ranges from 90° to 170°. The angle between two adjacent bent segments 34 ranges from 90° to 170°. For example, the angle between two adjacent bent segments 34 may be 90°, 100°, 110°, 120°, 130°, 140°, 150°, 160°, or 170°. By setting the angle between the two bent segments to range from 90° to 170°, a relatively large angle may be formed between the two bent segments, which makes a bending degree of the bent portion 33 relatively small, facilitating processing and manufacturing. In addition, when the heat dissipation member 31 internally has a heat dissipation channel 36 to allow for flow of a heat dissipation medium, in response to the angle between the two bent segments 34 being too small, relatively large resistance to the flow of the heat dissipation medium is caused when the heat dissipation medium flows through a part between the two bent segments 34. By setting the angle between the two bent segments 34 to range from 90° to 170°, the resistance to the flow of the heat dissipation medium through the part between the two bent segments 34 can be reduced, and a flow guiding effect of the bent segment 34 can be ensured. In this way, smooth flow of the heat dissipation medium in the heat dissipation member 31 can be ensured, a heat dissipation effect of the heat dissipation member 31 on the electronic components 23 can be ensured, and the occurrence of unsmooth flow of the heat dissipation medium can be avoided.

According to some embodiments of the present disclosure, referring to FIG. 15 to FIG. 17 and FIG. 21 to FIG. 23, the first heat dissipation member 31a further comprises a non-bent portion 35 extending along a straight line. One of the plurality of bent segments 34 of the bent portion 33 connected to the non-bent portion 35 serves as a first bent segment 341. An angle between the non-bent portion 35 and the first bent segment 341 ranges from 90° to 170°. For example, the angle between the non-bent portion 35 and the first bent segment 341 may be 90°, 100°, 110°, 120°, 130°, 140°, 150°, 160°, 170°, or the like. By providing the non-bent portion 35, processing difficulty and a production cost of the first heat dissipation member 31a can be reduced to some extent. In addition, when the heat dissipation member 31 internally has the heat dissipation channel 36 to allow for the flow of the heat dissipation medium, in response to the angle between the non-bent portion 35 and the first bent segment 341 being too small, relatively large resistance to the flow of the heat dissipation medium is caused when the heat dissipation medium flows through a part between the non-bent portion 35 and the first bent segment 341. By setting the angle between the non-bent portion 35 and the first bent segment 341 to range from 90° to 170°, the resistance to the flow of the heat dissipation medium through the part between the non-bent portion 35 and the first bent segment 341 can be reduced, which can ensure a flow guiding effect of the first heat dissipation member 31a. In this way, the smooth flow of the heat dissipation medium in the heat dissipation member 31 can be ensured, the heat dissipation effect of the heat dissipation member 31 on the electronic component 23 can be ensured, and the occurrence of the unsmooth flow of the heat dissipation medium can be avoided. Meanwhile, by providing the non-bent portion 35, it can be further beneficial to the flow of the heat dissipation medium in the heat dissipation channel 36. In addition, the non-bent portion 35 may also be configured to dissipate heat from the electronic components with low heat generation or a region where the electronic components are densely arranged.

It should be explained that in response to the first bent segment 341 being of a straight structure, the angle between the non-bent portion 35 and the first bent segment 341 refers to an angle between a straight line where the non-bent segment 34 is located and a straight line where the first bent segment 341 is located. In response to at least part of the first bent segment 341 comprising an arc structure, the angle between the non-bent portion 35 and the first bent segment 341 refers to an angle between the straight line where the non-bent segment 34 is located and a tangent line at any point of the arc structure of the first bent segment 341.

According to some embodiments of the present disclosure, referring to FIG. 15 to FIG. 17 and FIG. 21 to FIG. 23, the at least one heat dissipation member 31 comprises a first heat dissipation member 31a having a heat dissipation main body 32 located at the outer peripheral sides of the plurality of electronic components 23. The heat dissipation main body 32 of the first heat dissipation member 31a is located at the outer peripheral sides of the plurality of electronic components 23. Through this arrangement, one first heat dissipation member 31a may improve a heat dissipation effect for the plurality of electronic components 23. In this way, the number of first heat dissipation members 31a can be reduced, reducing the production cost to some extent. Meanwhile, a space occupancy rate of the heat dissipation component 30 in the electric control module assembly 10 can be reduced, and the space utilization rate of the electric control module assembly 10 can be improved.

According to some embodiments of the present disclosure, referring to FIG. 15 to FIG. 17 and FIG. 21 to FIG. 23, the at least one heat dissipation member 31a comprises a first heat dissipation member 31a having a heat dissipation main body 32 located at the outer peripheral sides of the plurality of electronic components 23. At least part of the plurality of electronic components 23 are arranged in a length direction of the electric control board 22 to constitute an electronic component group 11. The heat dissipation main body 32 of the first heat dissipation member 31a extends in a circumferential direction of the electronic components 23 of the electronic component group 11. By disposing the electronic component group 11, spatial layout inside the electric control module assembly 10 can be regionalized and rationalized, while facilitating arrangement of the first heat dissipation member 31a and fully utilizing the internal space of the electric control module assembly 10. The heat dissipation main body 32 of the first heat dissipation member 31a extends in the circumferential direction of the electronic components 23 of the electronic component group 11, which can ensure the heat dissipation effect for the plurality of electronic components 23 in the electronic component group 11, improving the overall heat dissipation effect for the electric control module 20.

The at least part of the plurality of electronic components 23 are arranged in the length direction of the electric control board 22 to constitute the electronic component group 11, i.e., the plurality of electronic components 23 may be partially or entirely arranged in the length direction of the electric control board 22 to constitute the electronic component group 11.

For example, seven electronic components 23 are arranged in the length direction of the electric control board 22 to constitute the electronic component group 11, and the heat dissipation main body 32 of the first heat dissipation member 31a extends in a circumferential direction of the seven electronic components 23 in the electronic component group 11 to ensure the heat dissipation effect for each electronic component 23 in the electronic component group 11.

According to some embodiments of the present disclosure, referring to FIG. 15 to FIG. 17 and FIG. 21 to FIG. 23, the at least one heat dissipation member 31 comprises a first heat dissipation member 31a having a heat dissipation main body 32 located at the outer peripheral sides of the plurality of electronic components 23. At least part of the plurality of electronic components 23 are arranged in a length direction of the electric control board 22 to constitute an electronic component group 11. The first heat dissipation member 31a is disposed at each of two sides of the electronic component group 11 in a width direction of the electric control board 22. By disposing the electronic component group 11, the spatial layout inside the electric control module assembly 10 can be regionalized and rationalized, while facilitating the arrangement of the first heat dissipation member 31a and fully utilizing the internal space of the electric control module assembly 10. By providing the first heat dissipation member 31a at each of the two sides of the electronic component group 11 in the width direction of the electric control board 22, a heat transfer area between the heat dissipation main body 32 and the outer peripheral sides of the electronic components 23 can be increased, and thus the heat dissipation effect for the electronic components 23 can be improved, improving the overall heat dissipation effect for the electric control module 20.

The at least part of the plurality of electronic components 23 are arranged in the length direction of the electric control board 22 to constitute the electronic component group 11, i.e., the plurality of electronic components 23 may be partially or entirely arranged in the length direction of the electric control board 22 to constitute the electronic component group 11.

For example, the seven electronic components 23 are arranged in the length direction of the electric control board 22 to constitute the electronic component group 11, and one first heat dissipation member 31a is provided at each of the two sides of the electronic component group 11 in the width direction of the electric control board 22. The two first heat dissipation members 31a may ensure the heat dissipation effect for each electronic component 23 in the electronic component group 11.

According to some embodiments of the present disclosure, referring to FIG. 15 to FIG. 17 and FIG. 21 to FIG. 23, the at least one heat dissipation member 31 comprises a first heat dissipation member 31a having a heat dissipation main body 32 located at the outer peripheral sides of the plurality of electronic components 23. A peripheral side surface of each of the plurality of electronic components 23 is an electronic component side surface 232, and the heat dissipation main body 32 of the first heat dissipation member 31a is in thermally conductive connection with the electronic component side surface 232. Through this arrangement, heat generated by the electronic component 23 in thermally conductive connection with the heat dissipation main body 32 of the first heat dissipation member 31a during operation can be exchanged at the electronic component side surface 232 with the heat dissipation main body 32 of the first heat dissipation member 31a, controlling the temperature of the electronic component 23 within the normal operating temperature range to ensure the stability of the operation of the electronic component 23. An area of the electronic component side surface 232 of the electronic component 23 is relatively large, which thus can increase a thermally conductive area between the heat dissipation main body 32 and the electronic component 23, improving the heat dissipation effect for the first heat dissipation member 31a on the electronic component 23.

In some embodiments, the heat dissipation main body 32 of the first heat dissipation member 31a is in thermally conductive connection with the electronic component side surface 232, i.e., the heat dissipation main body 32 of the first heat dissipation member 31a may be directly thermally connected to the electronic component side surface 232, or the heat dissipation main body 32 of the first heat dissipation member 31a may be in thermally conductive connection with the electronic component side surface 232 through the thermally conductive layer.

According to some embodiments of the present disclosure, the at least one heat dissipation member 31 comprises a first heat dissipation member 31a having a heat dissipation main body 32 located at the outer peripheral sides of the plurality of electronic components 23. The at least one heat dissipation member 31 comprises a plurality of heat dissipation members 31 comprising a first heat dissipation member 31a and a second heat dissipation member 31b. An end surface of each of the plurality of electronic components 23 in a height direction of the electronic component 23 is an electronic component end surface 231, and the heat dissipation main body 32 of the second heat dissipation member 31b is in thermally conductive connection with the electronic component end surface 231. Heat generated by the electronic component 23 in thermally conductive connection with the heat dissipation main body 32 of the second heat dissipation member 31b during operation may be exchanged at the electronic component end surface 231 with the heat dissipation main body 32 of the first heat dissipation member 31a, controlling the temperature of the electronic component 23 within the normal operating temperature range to ensure the stability of the operation of the electronic component 23.

One second heat dissipation member 31b may be in thermally conductive connection with the electronic component end surface 231 of one or more electronic components 23, i.e., one second heat dissipation member 31b may dissipate heat from one of the electronic components 23 or the plurality of electronic components 23.

In some embodiments, the second heat dissipation member 31b may be of a straight structure, which allows the second heat dissipation member 31b to have a simple structure and be convenient to process and form. Moreover, when the heat dissipation medium flows inside the second heat dissipation member 31b, it is beneficial to the smooth flow of the heat dissipation medium, ensuring the heat dissipation effect.

In some embodiments, the second heat dissipation member 31b may be bent. For example, when the second heat dissipation member 31b is in thermally conductive connection or thermal contact with the plurality of electronic components 23, the second heat dissipation member 31b may be bent in the height direction of the electronic component 23, to enable the second heat dissipation member 31b to be directly or indirectly thermally connected to the electronic component end surfaces 231 of the plurality of electronic components 23 with different heights. Through this arrangement, the number of second heat dissipation members 31b can be reduced, enabling a single second heat dissipation member 31b to dissipate heat from the plurality of electronic components 23 simultaneously.

For example, the heat dissipation member 31 having the heat dissipation main body 32 located at the outer peripheral sides of the electronic components 23 is the first heat dissipation member 31a. There are a relatively large number of electronic components 23 in heat transfer with the first heat dissipation member 31a and arranged in a complex manner, with their outer peripheral sides having a relatively large area. By providing the first heat dissipation member 31a, a heat transfer area between the electronic components 23 and the heat dissipation component 30 can be increased, and thus the heat dissipation effect for the plurality of electronic components 23 in the electric control component 21 can be improved. The heat dissipation member 31 comprises a second heat dissipation member 31b having a heat dissipation main body 32 located at the electronic component end surface 231. There is one electronic component 23 in thermally conductive connection with the second heat dissipation member 31b. An electronic component end surface 231 of this electronic component 23 is of a straight structure, and has a larger area than the area of the outer peripheral side. By providing the second heat dissipation member 31b in thermally conductive connection with the electronic component end surface 231, a thermally conductive area between the electronic component 23 and the heat dissipation component 30 can be increased, and thus the heat dissipation effect for this electronic component 23 can be improved. In addition, the second heat dissipation member 31b in thermally conductive connection with the electronic component end surface 231 has a relatively simple structure, which can facilitate processing and manufacturing of the second heat dissipation member 31b.

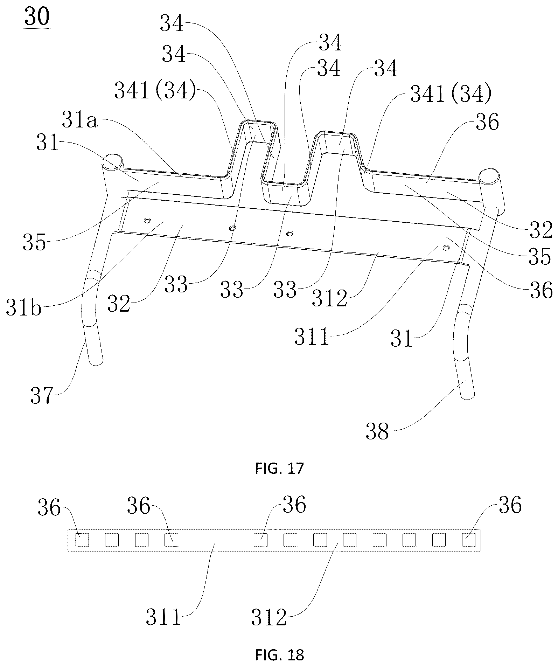

According to some embodiments of the present disclosure, referring to FIG. 17, the heat dissipation main body 32 of the second heat dissipation member 31b comprises a fixing portion 311 and a heat dissipation portion 312. The heat dissipation portion 312 has a heat dissipation channel 36 to allow for flow of a heat dissipation medium, and the fixing portion 311 is connected to the electric control board 22 by a fastener. By providing the fixing portion 311, the fixing portion 311 may be connected to the electric control board 22 by the fastener to position the second heat dissipation member 31b, which ensures stability of a position of the second heat dissipation member 31b, and avoids an impact on the heat dissipation effect for the electronic component 23 due to positional instability of the second heat dissipation member 31b. The heat dissipation portion 312 is formed with the heat dissipation channel 36 for the flow of the heat dissipation medium, and the heat dissipation channel 36 achieves a flow guiding effect on the heat dissipation medium. The heat dissipation medium flows through the electronic component 23 through the heat dissipation channel 36 and may exchange heat with the electronic component 23, realizing a heat dissipation function for the electronic component 23.

According to some embodiments of the present disclosure, referring to FIG. 2 and FIG. 8 to FIG. 12, the heat dissipation component 30 comprises at least one heat dissipation member 31. The at least one heat dissipation member 31 comprises a heat dissipation main body 32 in thermally conductive connection with the electric control component 21. The heat dissipation main body 32 of the at least one heat dissipation member 31 is bent to be in thermally conductive connection with at least two electronic components 23 with different heights. The end surface of the electronic component 23 in the height direction of the electronic component 23 is the electronic component end surface 231, and the heat dissipation main body 32 is in thermally conductive connection with the electronic component end surface 231. By bending the heat dissipation main body 32, one heat dissipation main body 32 may be in thermally conductive connection with the electronic components 23 of different heights. The bent heat dissipation main body 32 may adapt to the electronic components 23 of different heights, which enables the heat dissipation main body 32 to fit well with the electronic components 23 of different heights, and thus can improve heat dissipation effect for the electronic components 23 of different heights and the overall heat dissipation effect for the electric control module 20.

In some embodiments, the heat dissipation component 30 comprises a third heat dissipation member 31c and a fourth heat dissipation member 31d. A heat dissipation main body 32 of the third heat dissipation member 31c comprises at least one straight segment 40 and a connection segment 41 connected between adjacent straight segments 40. An angle is formed between the straight segment 40 and the connection segment 41. The straight segment 40 is in thermally conductive connection with the electronic component end surface 231. Electronic components 23 corresponding to a plurality of straight segments 40 of one heat dissipation main body 32 have different heights. The fourth heat dissipation member 31d is of a straight structure and may be in thermally conductive connection with the electronic component end surface 231. By enabling the straight segment 40 of the heat dissipation main body 32 to be in thermally conductive connection with the electronic component end surface 231, it is possible to make the straight segment 40 of the heat dissipation main body 32 adapt to the electronic component end surface 231 of the electronic component 23, allow the straight segment 40 of the heat dissipation main body 32 to fit well with the electronic component end surface 231 of the electronic component 23, allow for a relatively large thermally conductive area between the heat dissipation main body 32 and the electronic component end surface 231 of the electronic component 23, and improve heat dissipation efficiency of the electronic component 23.

In some embodiments, the connection segment 41 of the heat dissipation main body 32 is configured to connect two adjacent straight segments 40, which may be in thermally conductive connection with the electronic components 23 of different heights, making the heat dissipation main body 32 have a relatively simple bent structure and easy to process and form. Since electronic components 23 corresponding to different straight segments 40 of one heat dissipation main body 32 have different heights, an angle is formed between a connection segment 41 connected between two adjacent straight segments 40 and each of the two adjacent straight segments 40. Through this arrangement, the heat dissipation main body 32 is enabled to be in thermally conductive connection with the electronic components 23 of different heights, while having a simple structure, facilitating production and processing.

For example, the angle between the straight segment 40 and the connection segment 41 ranges from 90° to 170°. For example, the angle between the straight segment 40 and the connection segment 41 may be 90°, 100°, 110°, 120°, 130°, 140°, 150°, 160°, 170°, or the like. By setting the angle between the straight segment 40 and the connection segment 41 to range from 90° to 170°, a relatively large angle is formed between the straight segment 40 and the connection segment 41, resulting in a relatively small bending degree of the heat dissipation main body 32, and facilitating processing and manufacturing. In addition, when the heat dissipation member 31 internally has the heat dissipation channel 36 to allow for the flow of the heat dissipation medium, in response to the angle between the straight segment 40 and the connection segment 41 being too small, relatively large resistance to the flow of the heat dissipation medium is caused when the heat dissipation medium flows through a part between the straight segment 40 and the connection segment 41. By setting the angle between the straight segment 40 and the connection segment 41 to range from 90° to 170°, resistance to the flow of the heat dissipation medium through the part between the straight segment 40 and the connection segment 41 can be reduced, which can ensure a flow guiding effect of the connection segment 41. In this way, the smooth flow of the heat dissipation medium in the heat dissipation member 31 can be ensured, the heat dissipation effect of the heat dissipation member 31 on the electronic component 23 can be ensured, and the occurrence of unsmooth flow of the heat dissipation medium caused by a relatively large bending degree of the heat dissipation main body 32 can be avoided.

In some embodiments, the electric control component 21 comprises electronic component groups 46 corresponding to the heat dissipation members 31. The electronic component groups 46 comprise a first electronic component group 46a and a second electronic component group 46b. There is a large height difference between at least part of adjacent electronic components 23 in the first electronic component group 46a. The bent third heat dissipation member 31c is in thermally conductive connection with the first electronic component group 46a. The electronic components 23 in the second electronic component group 46b have the same height or a small height difference. The fourth heat dissipation member 31d having a straight structure is in thermally conductive connection with the second electronic component group 46b. By providing the electronic component groups 46, the spatial layout inside the electric control module assembly 10 can be regionalized and rationalized. In addition, by providing the electronic component groups 46, rational classification can be performed on the electronic components 23 of different heights to facilitate the arrangement of the heat dissipation members 31.

According to some embodiments of the present disclosure, the heat dissipation component 30 is configured to dissipate heat from the electric control module 20 and comprises at least one heat dissipation member 31. The heat dissipation member 31 comprises a heat dissipation main body 32 in thermally conductive connection with the electric control component 21. The thermally conductive layer is disposed between the heat dissipation main body 32 and the electronic component 23 to ensure the connection and thermal conduction between the heat dissipation main body 32 and the electronic component 23. The thermally conductive layer may be one or more of a thermally conductive adhesive, thermally conductive silicone grease, a thermally conductive pad, or a thermally conductive metal. For example, the thermally conductive layer may be the thermally conductive adhesive, the thermally conductive silicone grease, the thermally conductive pad, or the thermally conductive metal. Alternatively, the thermally conductive layer may comprise at least two of the thermally conductive adhesive, the thermally conductive silicone grease, the thermally conductive pad, and the thermally conductive metal. When the thermally conductive layer comprises the at least two of the thermally conductive adhesive, the thermally conductive silicone grease, the thermally conductive pad, and the thermally conductive metal, the two thermally conductive structures may be stacked in a thickness direction of the thermally conductive layer, or mixed with each other to form the thermally conductive layer.

According to some embodiments of the present disclosure, the heat dissipation main body 32 is formed in a flat shape. At least one side of the heat dissipation main body 32 in a thickness direction of the heat dissipation main body 32 is opposite to the plurality of electronic components 23 or in thermally conductive connection with the plurality of electronic components 23. The heat dissipation main body 32 in a flat shape has a relatively large contact area with the electronic components 23, which can increase the heat transfer area between the electronic components 23 and the heat dissipation main body 32 to a greater degree, improving the heat dissipation effect for the electronic components 23. Meanwhile, the heat dissipation main body 32 in a flat shape can reduce the space occupancy rate of the heat dissipation member 31 to a greater degree.

The at least one side of the heat dissipation main body 32 in the thickness direction of the heat dissipation main body 32 is in thermally conductive connection with the electronic components 23, i.e., one side or each of two sides of the heat dissipation main body 32 in the thickness direction of the heat dissipation main body 32 may be in thermally conductive connection with the electronic components 23.

According to some embodiments of the present disclosure, the electric control module 20 comprises an electric control box 24. The electric control component 21 is disposed in the electric control box 24. An inner wall of the electric control box 24 is provided with a first limiting structure 25. At least part of the heat dissipation member 31 is engaged with the first limiting structure 25 to limit a position of the heat dissipation member 31. The electric control box 24 may achieve an isolation or protection effect on the electric control module 20 and the heat dissipation component 30 inside it, which prevents dust outside the electric control box 24 from entering the interior of the electric control box 24, and can improve a service life of an internal part of the electric control box 24 to some extent. The inner wall of the electric control box 24 is provided with the first limiting structure 25, and the at least part of the heat dissipation member 31 is engaged with the first limiting structure 25. Through this arrangement, a position limiting effect on the heat dissipation member 31 can be realized, the stability of the position of the heat dissipation member 31 can be ensured, and thus stability of the heat dissipation effect of the heat dissipation member 31 on the electronic components 23 can be ensured.

The at least part of the heat dissipation member 31 is engaged with the first limiting structure 25, i.e., the heat dissipation member 31 may be partially or entirely is engaged with the first limiting structure 25.

According to some embodiments of the present disclosure, the first limiting structure 25 comprises a first limiting groove 251. The at least part of the heat dissipation member 31 is received in the first limiting groove 251. For example, the heat dissipation member 31 may be partially or entirely received in the first limiting groove 251. The first limiting structure 25 realizes its position limiting effect on the heat dissipation member 31 through the first limiting groove 251. The heat dissipation member 31 is partially received in the first limiting groove 251, which makes an assembly process of the heat dissipation member 31 relatively simple and has a good position limiting effect.

A part of the heat dissipation member 31 is received in the first limiting groove 251, i.e., the heat dissipation member 31 may be partially or entirely received in the first limiting groove 251, to achieve the position limiting effect of the first limiting groove 251.

Referring to FIG. 3, according to some embodiments of the present disclosure, the heat dissipation component 30 comprises a heat dissipation member 31. The heat dissipation member 31 comprises a heat dissipation main body 32 located in the electric control box 24. The heat dissipation member 31 internally has a heat dissipation channel 36 to allow for flow of a heat dissipation medium. By providing the heat dissipation member 31, the heat dissipation member 31 internally has the heat dissipation channel 36, and the heat dissipation channel 36 has a flow guiding effect on the heat dissipation medium inside it. The heat dissipation main body 32 of the heat dissipation member 31 located in the electric control box 24 may exchange heat with the electronic components 23 in the electric control box through the flow of the heat dissipation medium inside it, realizing the heat dissipation function of the heat dissipation component 30.

Referring to FIG. 3 to FIG. 12, according to some embodiments of the present disclosure, the heat dissipation component 30 comprises a medium inlet pipe 37 and a medium outlet pipe 38. The heat dissipation channel 36 is in communication with the medium inlet pipe 37 and the medium outlet pipe 38. The heat dissipation medium enters the heat dissipation channel 36 through the medium inlet pipe 37, absorb in the heat dissipation channel 36 heat generated by the electronic component 23 during operation, and then flows out from the medium outlet pipe 38. Through this arrangement, the structure is simple, while the heat dissipation efficiency is relatively high.

Referring to FIG. 5 and FIG. 10, according to some embodiments of the present disclosure, a plurality of heat dissipation members 31 are provided and arranged in parallel. By arranging the heat dissipation members 31 in parallel, the heat dissipation members may share one medium inlet pipe 37 and one medium outlet pipe 38. Therefore, the number of medium inlet pipes 37 and the number of medium outlet pipes 38 in the electric control module assembly 10 can be reduced, reducing the production cost. Meanwhile, the structure is simple, and the space utilization rate can be improved. In addition, the plurality of heat dissipation members 31 arranged in parallel may dissipate heat from the electronic components 23 more uniformly, thus further improving the heat dissipation effect.

For example, referring to FIG. 5 and FIG. 10, the heat dissipation component 30 comprises two heat dissipation members 31 arranged in parallel and sharing one medium inlet pipe 37 and one medium outlet pipe 38, which can reduce the number of medium inlet pipes 37 and the number of medium outlet pipes 38, reducing the production cost, while having a simple structure and improving the space utilization rate. The heat dissipation medium enters heat dissipation channels 36 of the two heat dissipation members 31 through the medium inlet pipe 37. After each of the two heat dissipation members 31 absorbs the heat from the electronic components 23 during the flow of the heat dissipation medium, the heat dissipation medium converges at the medium outlet pipe 38, and then flows out from the medium outlet pipe 38, which thus makes heat dissipation for the electronic components 23 more uniform and can further improve the heat dissipation effect of the heat dissipation component 30.

Referring to FIG. 5 and FIG. 10, according to some embodiments of the present disclosure, the medium inlet pipe 37 and the medium outlet pipe 38 are located at two sides of the electric control board 22 in a length direction of the electric control board 22. The plurality of heat dissipation members 31 extend in the length direction of the electric control board 22 and are arranged in a width direction of the electric control board 22.

Through this arrangement, structures of the medium inlet pipe 37, the medium outlet pipe 38, and the heat dissipation channel 36 are made simple. Meanwhile, the internal space of the electric control module assembly can be fully utilized, resulting in a relatively reasonable layout. In addition, the heat dissipation members 31 extend in the length direction of the electric control board 22, and may be in contact with more electronic components 23 at the electric control board 22, improving the heat dissipation effect of the heat dissipation component 30. Moreover, the number of heat dissipation members 31 can be reduced, and lengths of the medium inlet pipe 37 and the medium outlet pipe 38 can be shortened.

For example, referring to FIG. 5 and FIG. 10, the two heat dissipation members 31 extend in the length direction of the electric control board 22, and are arranged in the width direction of the electric control board 22.

Referring to FIG. 4 and FIG. 9, according to some embodiments of the present disclosure, an inner wall of the electric control box 24 is provided with a third limiting structure 27. The medium inlet pipe 37 and the medium outlet pipe 38 cooperate with the third limiting structure 27 to limit positions of the medium inlet pipe 37 and the medium outlet pipe 38. The inner wall of the electric control box 24 is provided with the third limiting structure 27, which can realize a position limiting effect of the electric control box 24 on the medium inlet pipe 37 and the medium outlet pipe 38, ensure stability of the positions of the medium inlet pipe 37 and the medium outlet pipe 38, and thus ensure the stability of the heat dissipation of the heat dissipation member 31 on the electronic components 23.

For example, referring to FIG. 6, two limiting protrusions are formed at an inner wall edge of each of two sides of the first box 241 in a length direction of the first box 241 The four limiting protrusions each serve as the third limiting structures 27. Limiting notches engaged with the two limiting protrusions may be provided at a corresponding position of each of the medium inlet pipe 37 and the medium outlet pipe 38. A position limiting effect of the third limiting structure 27 on the medium inlet pipe 37 and the medium outlet pipe 38 is achieved through the engagement between the limiting protrusions and the limiting notches. In addition, through this arrangement, assembly of the medium inlet pipe 37 and the medium outlet pipe 38 with the electric control box 24 can be facilitated.

For another example, referring to FIG. 11, two detachable engagement holes are formed at each of the two sides of the first box 241 in the length direction of the first box 241. Each of the two engagement holes serves as the third limiting structure 27. The medium inlet pipe 37 and the medium outlet pipe 38 may respectively cooperate with the engagement holes, and are engaged at the corresponding positions of the electric control box 24 after the cooperation is completed, realizing the position limiting effect of the third limiting structure 27 on the medium outlet pipe 38 and the medium inlet pipe 37. In addition, through this arrangement, the assembly of the medium inlet pipe 37 and the medium outlet pipe 38 with the electric control box 24 can be facilitated.

Referring to FIG. 4 and FIG. 9, according to some embodiments of the present disclosure, a part of the medium inlet pipe 37 and a part of the medium outlet pipe 38 are located between an outer edge of the electric control board 22 and an inner wall of the electric control box 24. Through this arrangement, the arrangement of the heat dissipation component 30 inside the electric control box 24 can be made more reasonable, the internal space of the electric control box 24 can be fully utilized, and the space utilization rate can be improved. In addition, when the isolation structure is a gel structure, this arrangement can prevent the potting gel from entering the medium inlet pipe 37 and the medium outlet pipe 38 during the potting operation, which can ensure the heat dissipation effect of the heat dissipation component 30 while facilitating the execution of the potting operation inside the electric control box 24.

Referring to FIG. 1 and FIG. 2, according to some embodiments of the present disclosure, the heat dissipation member 31 is a phase-change heat dissipation element and comprises a heat absorption segment 42 and a heat dissipation segment 43. The heat dissipation medium in the heat dissipation member 31 is adapted to circulate and flow between the heat absorption segment 42 and the heat dissipation segment 43, and the heat absorption segment 42 comprises the heat dissipation main body 32. The heat absorption segment 42 of the heat dissipation member 31 is used to absorb heat generated by the electronic components 23 during operation to achieve the heat dissipation function for the electronic components 23. The heat dissipation segment 43 of the heat dissipation member 31 is used for heat dissipation of the heat dissipation medium, which can allow the heat dissipation medium to flow to the heat absorption segment 42 for heat absorption again after being subjected to the heat dissipation, realizing the circulation and flow of the heat dissipation medium between the heat absorption segment 42 and the heat dissipation segment 43.

During the operation of the heat dissipation member 31, the heat dissipation medium in the heat absorption segment 42 is in a liquid state. After absorbing the heat generated by the electronic components 23 during operation, the liquid heat dissipation medium converts from a liquid state to a gaseous state and flows to the heat dissipation segment 43 through the heat dissipation channel 36. The gaseous heat dissipation medium condenses in the heat dissipation segment 43, converts from a high-temperature gaseous state back to a low-temperature liquid state, and finally flows to the heat absorption segment 42 through the heat dissipation channel 36 to re-absorb the heat generated by the electronic components 23 during operation for the next heat dissipation cycle. The heat dissipation medium circulates and flows between the heat absorption segment 42 and the heat dissipation segment 43, and completes functions of heat absorption and dissipation through its phase change in the heat dissipation channel 36, realizing a cyclic heat dissipation function of the heat dissipation member 31 for the electronic components 23.

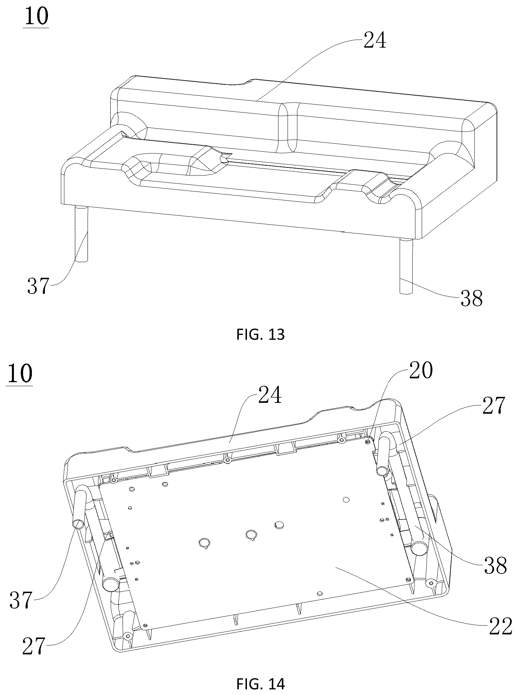

The electric control module assembly 10 according to some embodiments of the present disclosure is described below with reference to FIG. 13 to FIG. 18.

Referring to FIG. 13 to FIG. 18, the electric control module assembly 10 comprises an electric control module 20 and a heat dissipation component 30. The electric control module 20 comprises an electric control component 21 and an electric control box 24. The electric control component 21 comprises an electric control board 22 and a plurality of electronic components 23 disposed at the electric control board 22. The heat dissipation component 30 is configured to dissipate heat from the electric control module 20 and comprises two heat dissipation members 31. The two heat dissipation members 31 are a first heat dissipation member 31a and a second heat dissipation member 31b, respectively. Each of the heat dissipation members 31 comprises a heat dissipation main body 32. The heat dissipation main body 32 of one of the heat dissipation members 31 is located at the outer peripheral sides of the electronic components 23.

The heat dissipation member 31 comprises a first heat dissipation member 31a having a heat dissipation main body 32 located at the outer peripheral sides of the plurality of electronic components 23. The heat dissipation main body 32 of the first heat dissipation member 31a extends along a non-straight line, and extends in the circumferential direction of the electronic components 23. The heat dissipation main body 32 of the first heat dissipation member 31a comprises three bent portions 33. Each of the three bent portions 33 comprises three bent segments 34 connected sequentially in an extending direction of the first heat dissipation member 31a. An angle is formed between two adjacent bent segments 34, and ranges from 90° to 170°. The first heat dissipation member 31a further comprises a non-bent portion 35 extending along a straight line. A bent segment 34 of the bent portion 33 connected to the non-bent portion 35 serves as a first bent segment 341. An angle between the non-bent portion 35 and the first bent segment 341 ranges from 90° to 170°. At least part of the plurality of electronic components 23 are arranged in a length direction of the electric control board 22 to constitute an electronic component group. The heat dissipation main body 32 of the first heat dissipation member 31a is arranged around the outer peripheral sides of the electronic components 23 of the electronic component group.

A peripheral side surface of each of the plurality of electronic components 23 is an electronic component side surface 232, and the heat dissipation main body 32 of the first heat dissipation member 31a is in thermally conductive connection with the electronic component side surface 232. An end surface of each of the plurality of electronic components 23 in a height direction of the electronic component 23 is an electronic component end surface 231, and the heat dissipation main body 32 of the second heat dissipation member 31b is in thermally conductive connection with the electronic component end surface 231. The heat dissipation main body 32 of the second heat dissipation member 31b comprises a fixing portion 311 and a heat dissipation portion 312. The heat dissipation portion 312 has a heat dissipation channel 36 to allow for flow of a heat dissipation medium, and the fixing portion 311 is connected to the electric control board 22 by a fastener. A thermally conductive layer is disposed between the heat dissipation main body 32 and the plurality of electronic components 23, which is thermally conductive silicone grease. The heat dissipation main body 32 is formed in a flat shape. At least one side of the heat dissipation main body 32 in a thickness direction of the heat dissipation main body 32 is opposite to the plurality of electronic components 23 or in thermally conductive connection with the plurality of electronic components 23.

The electric control component 21 is disposed in the electric control box 24, and an inner wall of the electric control box 24 is provided with a first limiting structure 25. The first heat dissipation member 31a cooperates with the first limiting structure 25 to limit a position of the first heat dissipation member 31a. The first limiting structure 25 comprises a first limiting groove 251, and a part of the first heat dissipation member 31a is received in the first limiting groove 251.

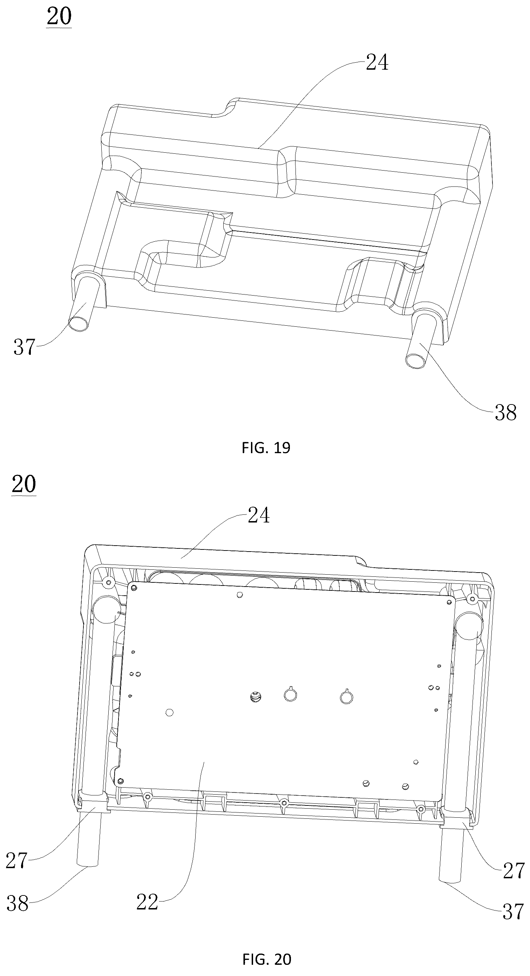

The heat dissipation member 31 internally has the heat dissipation channel 36 to allow for the flow of the heat dissipation medium. The heat dissipation component 30 comprises a medium inlet pipe 37 and a medium outlet pipe 38. The heat dissipation channel 36 is in communication with the medium inlet pipe 37 and the medium outlet pipe 38. The first heat dissipation member 31a and the second heat dissipation member 31b are arranged in parallel. The medium inlet pipe 37 and the medium outlet pipe 38 are located at two sides of the electric control board 22 in a length direction of the electric control board 22. The heat dissipation member 31 extends in the length direction of the electric control board 22. The first heat dissipation member 31a and the second heat dissipation member 31b are arranged in a width direction of the electric control board 22. The inner wall of the electric control box 24 is further provided with a third limiting structure 27. The medium inlet pipe 37 and the medium outlet pipe 38 cooperate with the third limiting structure 27 to limit positions of the medium inlet pipe 37 and the medium outlet pipe 38. The electric control module assembly 10 according to other embodiments of the present disclosure is described below with reference to FIG. 19 to FIG. 23.

Referring to FIG. 19 to FIG. 23, compared with the electric control module assembly 10 in FIG. 1 to FIG. 6, a difference of the electric control module assembly 10 in this embodiment lies in that the heat dissipation component 30 comprises three heat dissipation members 31, which are two first heat dissipation members 31a and one second heat dissipation member 31b, respectively. Each of the two first heat dissipation members 31a is provided with a bent portion 33 comprising three bent segments 34.

In addition, the two first heat dissipation members 31a are disposed at two sides of the electronic component group 11 in the width direction of the electric control board 22, and are connected in parallel with one second heat dissipation member 31b. The two first heat dissipation members 31a are located at the outer peripheral sides of the electronic components 23, and respectively disposed at two sides of the electric control board 22 in the width direction of the electric control board 22, which can increase a heat transfer area between the electronic components 23 and the heat dissipation component 30, improve a heat dissipation effect for the electronic components 23, and thus improve an overall heat dissipation effect for the electric control module 20.

According to an embodiment of a second aspect of the present disclosure, a potting method of the electric control module assembly 10 according to the embodiment of the first aspect of the present disclosure described above comprises: assembling the electric control component 21 and the heat dissipation component 30 into the electric control box 24 to form a pre-assembled assembly; and adjusting the pre-assembled assembly to orient a potting side of the electric control box 24 to face upward. The electric control board 22 has a first side 221 and a second side 222 opposite to each other in a thickness direction of the electric control board 22. The potting side of the electric control box 24 may be the first side 221 or the second side 222.

For example, when potting is performed through a potting port 44 at a gap between an outer edge of the electric control board 22 and an inner wall of a first box 241, the second side 222 of the electric control board 22 is the potting side, and the pre-assembled assembly is adjusted to orient the second side 222 of the electric control board 22 to face upwards. When the potting is performed through a first potting hole 45 at the electric control board 22, the second side 222 of the electric control board 22 is the potting side, and the pre-assembled assembly is adjusted to orient the second side 222 of the electric control board 22 to face upwards. When the potting is performed through a second potting hole located at the electric control box 24, the first side 221 of the electric control board 22 is the potting side, and the pre-assembled assembly is adjusted to orient the first side 221 of the electric control board 22 to face upwards.

Gel is potted into the electric control box 24 from the potting side of the electric control box 24 to form an isolation structure.

For the potting method according to the embodiment of the present disclosure, the isolation structure may be formed inside the electric control box 24, which can allow the electronic components 23 to be isolated from air, and thus prevent condensation from being generated at the electronic components 23 of the electric control module 20, improving reliability, stability, and safety of the electric control module 20. In addition, when flammable and explosive gas is present in an environment where the electric control module 20 is located, the isolation structure is provided and encapsulates the outer surfaces of the electronic components 23, which can eliminate safety hazards of ignition and explosion caused by contact between the flammable and explosive gas and the electronic components 23, while achieving effects of improving vibration resistance performance of the electric control module 20, preventing disengagement of the electronic components 23, buffering and protecting the electronic components 23, and dust prevention.

According to some embodiments of the present disclosure, said assembling the electric control component 21 and the heat dissipation component 30 into the electric control box 24 to form the pre-assembled assembly comprises: assembling a part of the heat dissipation component 30 to the electric control component 21, assembling the electric control component 21 assembled with the heat dissipation component 30 into a first box 241 of the electric control box 24, and orienting a first side 221 of the electric control board 22 towards the first box 241. The first side 221 of the electric control board 22 is provided with the plurality of electronic components 23.

Said adjusting the pre-assembled assembly to orient the potting side of the electric control box 24 to face upwards comprises: adjusting the pre-assembled assembly to orient a second side 222 of the electric control board 22 to face upwards.

Said potting the gel into the electric control box 24 from the potting side of the electric control box 24 to form the isolation structure comprises: potting the gel into the first box 241 from the second side 222 of the electric control board 22 to form the isolation structure, and assembling a second box 242 of the electric control box 24 to the first box 241. During the potting process, the potting gel is potted into a filling space from the second side 222 of the electric control board 22, flows from top to bottom under the action of gravity to flow from the second side 222 of the electric control board 22 to a lowest point of the filling space until the entire filling space is filled, and thus may encapsulate the outer surfaces of the plurality of electronic components 23 located inside the filling space, which allows the electronic components 23 to be isolated from the air, and prevents the condensation from being generated at the electronic components 23 due to cooling. After the potting is completed, the second box 242 of the electric control box 24 is assembled to the first box 241, which is simple to operate.

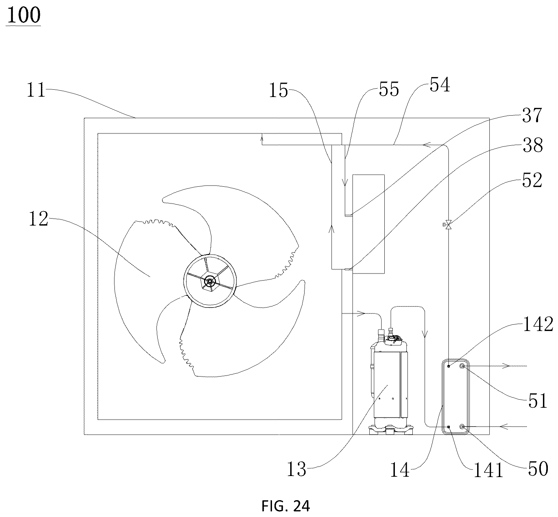

Referring to FIG. 1 and FIG. 24, an outdoor unit 100 according to an embodiment of a third aspect of the present disclosure comprises an outdoor unit casing 11, an outdoor heat exchanger, an outdoor fan 12, a compressor assembly 13, and the electric control module assembly 10 according to the embodiment of the first aspect of the present disclosure described above. The outdoor heat exchanger, the outdoor fan 12, the compressor assembly 13, and the electric control module assembly 10 are each disposed in the outdoor unit casing 11. During operation of the outdoor unit 100, a temperature of the electric control module 20 rises. By providing the heat dissipation component 30 in the electric control module assembly 10, heat generated by the electric control module 20 during its operation may be dissipated through the heat dissipation component 30, controlling a temperature of the electric control component 21 within a normal operating temperature range to ensure stability of operation of the electric control module 20.

For the outdoor unit 100 according to the embodiment of the present disclosure, by providing the electric control module assembly 10 as described above, a heat dissipation effect for the electric control module 20 can be improved. By providing an isolation structure, the electronic components 23 may be isolated from air, which can thus prevent condensation from being generated at the electronic components 23 of the electric control module 20, improving reliability, stability, and safety of the electric control module 20. In addition, when flammable and explosive gas is present in an environment where the electric control module 20 is located, the isolation structure is provided and encapsulates the outer surfaces of the electronic components 23, which can eliminate safety hazards of ignition and explosion caused by contact between flammable and explosive gas and the electronic components 23, while achieving effects of improving vibration resistance performance of the electric control module 20, preventing disengagement of the electronic components 23, buffering and protecting the electronic components 23, and dust prevention.

Referring to FIG. 1 and FIG. 24, according to some embodiments of the present disclosure, a refrigerant circulation system of the outdoor unit 100 comprises a cooling portion 15 configured to dissipate heat from the electric control module 20. The cooling portion 15 is in thermally conductive connection with the heat dissipation component 30, or at least part of the cooling portion 15 constitutes the heat dissipation component 30.

The refrigerant circulation system of the outdoor unit 100 comprises the cooling portion 15 configured to dissipate heat from the electric control module 20. Through this arrangement, a refrigerant in the refrigerant circulation system may be utilized to take away heat generated by the electric control module 20.

The cooling portion 15 is in thermally conductive connection with the heat dissipation component 30. The heat generated by the electric control module 20 is transferred to the cooling portion 15 through the heat dissipation component 30, and then is taken away by the refrigerant flowing through the cooling portion 15, which can realize indirect heat dissipation and cooling of the electric control module 20 by the refrigerant.

For example, referring to FIG. 1 and FIG. 2, the heat dissipation component 30 comprises two heat dissipation members 31. Each of two heat dissipation members 31 is a phase-change heat dissipation element and comprises a heat absorption segment 42 and a heat dissipation segment 43. A heat dissipation medium in the heat dissipation member 31 is adapted to circulate and flow between the heat absorption segment 42 and the heat dissipation segment 43. The heat absorption segment 42 comprises a heat dissipation main body 32. The heat dissipation segment 43 is in thermally conductive connection with the cooling portion 15 through a thermally conductive substrate 53, and the cooling portion 15 may exchange heat with the heat dissipation medium of the heat dissipation segment 43 to realize a heat dissipation function for the heat dissipation segment 43.

At least part of the cooling portion 15 constitutes the heat dissipation component 30, i.e., the cooling portion 15 may partially or entirely form the heat dissipation component 30. The heat generated by the electric control module 20 may be directly transferred to the cooling portion 15, and is taken away by the refrigerant flowing through the cooling portion 15, which can realize indirect heat dissipation and cooling of the electric control module 20 by the refrigerant. This arrangement has a simple structure, which can omit a thermally conductive member connected between the cooling portion 15 and the electric control module 20, and enable the cooling portion 15 to better absorb the heat generated by the electric control module 20.

For example, referring to FIG. 3 and FIG. 8, the at least part of the cooling portion 15 constitutes the heat dissipation component 30. The heat generated by the electric control module 20 may be directly transferred to the cooling portion 15, and taken away by the refrigerant flowing through the cooling portion 15, which can realize the indirect heat dissipation and cooling of the electric control module 20 by the refrigerant.

Referring to FIG. 1 and FIG. 24, according to some embodiments of the present disclosure, the outdoor unit 100 further comprises a water-circuit heat exchange assembly comprising a water-circuit heat exchanger 14. The water-circuit heat exchanger 14 has a water flow channel and a refrigerant channel exchanging heat with each other, and a water cooling portion 15 is connected between the refrigerant channel and an inlet of the outdoor heat exchanger. The water flow channel and the refrigerant channel in the water-circuit heat exchanger 14 exchange heat with each other, which can realize a heat exchange function of the water-circuit heat exchanger 14. After the refrigerant in the refrigerant circulation system enters the refrigerant channel of the water-circuit heat exchanger 14, water in the water flow channel and the refrigerant in the refrigerant channel exchange heat with each other. After the heat exchange, the water in the water flow channel flows out of the water-circuit heat exchanger 14, and its temperature may be changed. The water with a temperature adjusted to a predetermined value may be introduced into the room to provide domestic water or into an indoor heat exchanger of an indoor unit to adjust an indoor air temperature.

In some embodiments, the water-circuit heat exchanger 14 may be a plate heat exchanger.

The water-circuit heat exchanger 14 has a first refrigerant inlet/outlet 141 and a second refrigerant inlet/outlet 142. Each of the first refrigerant inlet/outlet 141 and the second refrigerant inlet/outlet 142 is in communication with the refrigerant channel. The refrigerant flows into the refrigerant channel from one of the first refrigerant inlet/outlet 141 and the second refrigerant inlet/outlet 142 and flows out of the refrigerant channel from another one of the first refrigerant inlet/outlet 141 and the second refrigerant inlet/outlet 142. The outdoor heat exchanger has a first heat exchange inlet/outlet and a second heat exchange inlet/outlet. The refrigerant flows into the outdoor heat exchanger from one of the first heat exchange inlet/outlet and the second heat exchange inlet/outlet and flows out of the outdoor heat exchanger from another one of the first heat exchange inlet/outlet and the second heat exchange inlet/outlet. The cooling portion 15 is connected between the second refrigerant inlet/outlet 142 and the first heat exchange inlet/outlet.

For example, in a case where the outdoor heat exchanger functions as an evaporator and the water-circuit heat exchanger 14 functions as a condenser, a refrigerant discharged from the compressor assembly 13 flows into the refrigerant channel of the water-circuit heat exchanger 14 through the first refrigerant inlet/outlet 141 and flows out through the second refrigerant inlet/outlet 142. The refrigerant flowing out of the water-circuit heat exchanger 14 may flow through the cooling portion 15 and take away the heat generated by the electric control module 20. The refrigerant flowing out of the cooling portion 15 flows into the outdoor heat exchanger through the first heat exchange inlet/outlet, flows out of the outdoor heat exchanger through the second heat exchange inlet/outlet, and returns to the compressor assembly again for further compression and circulation. After the refrigerant in the refrigerant circulation system enters the refrigerant channel of the water-circuit heat exchanger 14, the water in the water flow channel and the refrigerant in the refrigerant channel exchange heat with each other. After the heat exchange is completed, the refrigerant flows through the cooling portion 15. At this time, the refrigerant flowing into the cooling portion 15 has a relatively low temperature after heat exchange in the water-circuit heat exchanger 14. The refrigerant flowing through the cooling portion 15 may dissipate heat from the electric control module 20. Moreover, compared with the temperature of the refrigerant in a return air pipe of the refrigerant circulation system, the refrigerant that has flowed through the water-circuit heat exchanger 14 and not yet entered the outdoor heat exchanger not only meets heat dissipation for the electric control module 20, but also has a relatively higher temperature than the temperature of the refrigerant in the return air pipe, which can reduce a risk of condensation caused by the heat dissipation for the electric control module 20 with the refrigerant. In addition, the refrigerant that has passed through the water-circuit heat exchanger 14 is used to dissipate heat from the electric control module 20, which can prioritize heat exchange performance of the water-circuit heat exchanger 14 and meet an indoor heat exchange requirement.

In a case where the outdoor heat exchanger functions as a condenser and the water-circuit heat exchanger 14 functions as an evaporator, the refrigerant discharged from the compressor assembly 13 flows into the outdoor heat exchanger through the second heat exchange inlet/outlet and flows out through the first heat exchange inlet/outlet. The refrigerant flowing out of the outdoor heat exchanger may flow through the cooling portion 15 and take away the heat generated by the electric control module 20. The refrigerant flowing out of the cooling portion 15 flows into the water-circuit heat exchanger 14 through the second refrigerant inlet/outlet 142, flows out of the water-circuit heat exchanger 14 through the first refrigerant inlet/outlet 141, and returns to the compressor assembly again for further compression and circulation. The refrigerant in the refrigerant circulation system enters the outdoor heat exchanger for heat exchange, and flows through the cooling portion 15 after the heat exchange is completed. At this time, the refrigerant flowing into the cooling portion 15 has a relatively low temperature after heat exchange in the outdoor heat exchanger. The refrigerant flowing through the cooling portion 15 may dissipate heat from the electric control module 20. Moreover, compared with the temperature of the refrigerant in the return air pipe of the refrigerant circulation system, the refrigerant that has flowed through the outdoor heat exchanger and not yet entered the water-circuit heat exchanger 14 not only meets the heat dissipation for the electric control module 20, but also has a relatively higher temperature than the temperature of the refrigerant in the return air pipe, which can reduce the risk of condensation caused by the heat dissipation for the electric control module 20 with the refrigerant.

In some embodiments, the water-circuit heat exchanger 14 further comprises a water-circuit inlet 50 and a water-circuit outlet 51. Water entering the water flow channel through the water-circuit inlet 50 exchanges heat with the refrigerant in the refrigerant channel. After the heat exchange, the water in the water flow channel flows out of the water-circuit heat exchanger 14, which can change its temperature, and then flows out of the water-circuit outlet 51. The water with a temperature adjusted to the predetermined value may be introduced into the room to provide the domestic water or into the indoor heat exchanger of the indoor unit to adjust the indoor air temperature.

In some embodiments, the refrigerant circulation system may be provided with a throttling component 52 to control parameters such as a flow rate of the refrigerant in the refrigerant circulation system.

In some embodiments, referring to FIG. 24, the refrigerant circulation system comprises a connection pipeline 54 and a cooling bypass 55 that are connected between the refrigerant channel of the water-circuit heat exchanger 14 and the heat exchanger. The cooling bypass 55 is connected in parallel with a part of the connection pipeline 54. A part of the cooling bypass 55 constitutes the cooling portion 15. A refrigerant in the connection pipeline 54 of the refrigerant system is used to ensure indoor heat exchange performance to realize a temperature adjustment function. A refrigerant in the cooling portion 15 of the cooling bypass 55 is used to meet a cooling requirement of the electric control module 20 to realize the heat dissipation for the electric control module 20. By connecting at least part of an outlet segment of a main pipeline in parallel with the cooling bypass 55, while achieving the heat dissipation for the electric control module 20, performance of the outdoor unit 100 can be ensured.

Referring to FIG. 1 to FIG. 12, a heating, ventilation and air conditioning equipment according to an embodiment of a fourth aspect of the present disclosure comprises the outdoor unit 100 according to the embodiment of the third aspect of the present disclosure described above. The heating, ventilation and air conditioning equipment may be an air conditioning system, a heat pump system, or the like.

For the heating, ventilation and air conditioning equipment according to the embodiment of the present disclosure, by providing the outdoor unit 100 as described above, an electric control module assembly 10 of the outdoor unit 100 is provided with a heat dissipation component 30, which can improve a heat dissipation effect for the electric control module 20. The electric control module assembly 10 is also provided with an isolation structure, which can make the electronic components 23 isolated from air, and thus prevent condensation from being generated at the electronic components 23 of the electric control module 20, improving reliability, stability, and safety of the electric control module 20. In addition, when the flammable and explosive gas is present in an environment where the electric control module 20 is located, the isolation structure is provided and encapsulates the outer surfaces of the electronic components 23, which can eliminate safety hazards of ignition and explosion caused by contact between the flammable and explosive gas and the electronic components 23, while achieving effects of improving vibration resistance performance of the electric control module 20, preventing disengagement of the electronic component 23, buffering and protecting the electronic components 23, and dust prevention.

The electric control module assembly 10 according to some embodiments of the present disclosure is described below with reference to FIG. 3 to FIG. 12.

Referring to FIG. 3 to FIG. 12, in this embodiment, the electric control module assembly 10 comprises an electric control module 20 and a heat dissipation component 30. The electric control module 20 comprises an electric control box 24 and an electric control component 21 disposed in the electric control box 24. The electric control component 21 comprises an electric control board 22 and a plurality of electronic components 23 disposed at the electric control board 22. The heat dissipation component 30 is configured to dissipate heat from the electric control module 20. The electric control box 24 is internally provided with an isolation structure that encapsulates outer surfaces of the plurality of electronic components 23 to isolate the electronic component 23 from air. The isolation structure is a gel structure.

A part of the heat dissipation component 30 is located in the electric control box 24 and is in thermally conductive connection with the electric control component 21. The isolation structure is filled in a space defined by the electric control box 24, the electric control component 21, and the heat dissipation component 30. The electric control component 21 and the heat dissipation component 30 are connected into one piece by the isolation structure. The heat dissipation component 30 comprises a plurality of heat dissipation members 31. Each of the plurality of heat dissipation members 31 comprises a heat dissipation main body 32 in thermally conductive connection with the electric control component 21. An end surface of the electronic component 23 in a height direction of the electronic component 23 is an electronic component end surface 231, and a peripheral side surface of the electronic component 23 is an electronic component side surface 232. The heat dissipation main body 32 may be in thermally conductive connection with the electronic component end surface 231 or the electronic component side surface 232.

For example, referring to FIG. 3 to FIG. 7, in this embodiment, the heat dissipation component 30 comprises a first heat dissipation member 31a and a second heat dissipation member 31b. The first heat dissipation member 31a is provided with a bent portion 33 formed by sequentially connecting three bent segments 34. A heat dissipation main body 32 of the first heat dissipation member 31a is in thermally conductive connection with the electronic component side surface 232. The second heat dissipation member 31b is of a straight structure and is in thermally conductive connection with the electronic component end surface 231.

For example, referring to FIG. 8 to FIG. 12, in this embodiment, the heat dissipation component 30 comprises a third heat dissipation member 31c and a fourth heat dissipation member 31d. The electric control component 21 comprises a first electronic component group 46a and a second electronic component group 46b. The first electronic component group 46a and the second electronic component group 46b are in thermally conductive connection with the third heat dissipation component 30 and the fourth heat dissipation component 30, respectively. The first electronic component group 46a comprises a plurality of electronic components 23 of three different heights. A heat dissipation main body 32 of the third heat dissipation member 31c is bent to be in thermally conductive connection with electronic component end surfaces 231 of the electronic components 23 of three different heights. The second electronic component group 46b comprises an electronic component 23. The fourth heat dissipation member 31d is of a straight structure and is in thermally conductive connection with the electronic component end surface 231 of the electronic component 23 in the second electronic component group 46b.

An inner wall of the electric control box 24 or the electric control board 22 is provided with a first limiting structure 25 configured to limit a position of the heat dissipation component 30. The electric control board 22 has a first side 221 and a second side 222 opposite to each other in a thickness direction of the electric control board 22. A filling space is defined between the first side 221 of the electric control board 22 and the electric control box 24. The electronic components 23 are disposed at the first side 221 of the electric control board 22 and located in the filling space, and the filling space is filled with the isolation structure.

A part of the heat dissipation component 30 is located in the filling space and is in thermally conductive connection with the electronic components 23. The isolation structure is filled in a gap between an outer edge of the electric control board 22 and the inner wall of the electric control box 24. A surface of the second side 222 of the electric control board 22 serves as a board back surface. The isolation structure is flush with or protrudes from the board back surface and covers the board back surface. At least part of an inner wall of the electric control box 24 facing towards the first side 221 of the electric control board 22 is formed as a profiling structure, which has a similar shape to that of the first side 221 of the corresponding electric control component 21.

The electric control box 24 comprises a first box 241 and a second box 242 that are formed independently. The electric control component 21 is disposed in the first box 241. The first side 221 of the electric control board 22 faces towards the first box 241, and a filling space is defined between the first side 221 of the electric control board 22 and the first box 241. An inner wall of the first box 241 is formed with a second limiting structure 26 configured to limit a position of the electric control board 22 and a first fixing column 28 configured to fix the electric control board 22. During assembly of the electric control board 22 with the first box 241, through the second limiting structure 26, positioning of the electric control board 22 and the first box 241 can be facilitated. After the positioning is completed, the electric control board 22 and the first box 241 may be connected and fixed through the first fixing column 28.

A gap is formed between the outer edge of the electric control board 22 and the inner wall of the first box 241. At least part of the gap may constitute a potting port 44 in communication with the filling space. The electric control board 22 also has a first potting hole 45 in communication with the filling space. The first potting hole 45 has an equivalent diameter greater than 10 mm, and is located in a center portion of the electric control board 22.

The first box 241 is internally provided with a second fixing column 29 connected to the second box 242. A surface of the second side 222 of the electric control board 22 serves as a board back surface. The second fixing column 29 is located at an outer peripheral side of the electric control board 22 and protrudes from the board back surface.

The heat dissipation component 30 is led out from the potting side of the electric control box 24. A wiring harness connected to the electric control component 21 is led out from the potting side of the electric control box 24. The heat dissipation component 30 comprises a heat dissipation member 31. The heat dissipation member 31 comprises a heat dissipation main body 32 located in the electric control box 24. The heat dissipation member 31 internally has a heat dissipation channel 36 to allow for flow of a heat dissipation medium.

The heat dissipation component 30 comprises a medium inlet pipe 37 and a medium outlet pipe 38. The heat dissipation channel 36 is in communication with the medium inlet pipe 37 and the medium outlet pipe 38. There are two heat dissipation members 31 arranged in parallel. The medium inlet pipe 37 and the medium outlet pipe 38 are located at two sides of the electric control board 22 in a length direction of the electric control board 22. The two heat dissipation members 31 extend in the length direction of the electric control board 22, and are arranged in a width direction of the electric control board 22.

The inner wall of the electric control box 24 is further provided with a third limiting structure 27. The medium inlet pipe 37 and the medium outlet pipe 38 cooperate with the third limiting structure 27 to limit positions of the medium inlet pipe 37 and the medium outlet pipe 38. A part of the medium inlet pipe 37 and a part of the medium outlet pipe 38 are located between the outer edge of the electric control board 22 and the inner wall of the electric control box 24.

The heat dissipation component 30 may dissipate heat from the electric control module 20. Moreover, the isolation structure is provided and encapsulates the outer surfaces of the electronic components 23 to isolate the electronic components 23 from the air, which thus can prevent condensation from being generated at the electronic components 23 of the electric control module 20 and improve reliability, stability, and safety of the electric control module 20.

The potting method of the electric control module assembly 10 of this embodiment is described below with reference to FIG. 3 to FIG. 12. The potting method comprises: assembling the electric control component 21 and the heat dissipation component 30 into the electric control box 24 to form a pre-assembled assembly. During the formation of the pre-assembled assembly, the assembly of the electric control board 22 and the heat dissipation component 30 is completed according to a corresponding relationship between the electronic components 23 at the electric control board 22 and the heat dissipation member 31, to make the heat dissipation component 30 fixed at the electric control board 22. For example, the electric control board 22 and the heat dissipation component 30 may be positioned by bonding. After the fixing is completed, the electric control board 22 is inverted and installed into the first box 241 to orient the first side 221 of the electric control board 22 to face towards the first box 241, and positioning of the heat dissipation component 30, the electric control board 22, and the first box 241 is completed through the first limiting structure 25, the second limiting structure 26, and the third limiting structure 27. Finally, the electric control board 22 and the first box 241 are connected and fixed through the first fixing column 28 to form the pre-assembled assembly. For example, the connection and fixation of the electric control board 22 and the first box 241 may be completed through the cooperation between the fastener and the first fixing column 28. At this time, the filling space is defined between the first side 221 of the electric control board 22 and the electric control box 24. Moreover, the electronic components 23 and the heat dissipation component 30 are located in the filling space.

The pre-assembled assembly is adjusted to orient the potting side of the electric control box 24 to face upwards. During a process of potting the gel from the potting side of the electric control board 22 to the filling space, the gel may be potted into the filling space through a potting port 44 formed by a gap between the electric control board 22 and the inner wall of the first box 241, or through the first potting hole 45 at the electric control board 22, or through both the potting port 44 and the first potting hole 45.

The gel is potted into the electric control box 24 from the potting side of the electric control box 24 to form the isolation structure. During the potting process, the potting gel is potted into the filling space from the potting side of the electric control board 22, flows from top to bottom under the action of gravity to flow from the second side 222 of the electric control board 22 to the lowest point of the filling space until the entire filling space is filled, and thus may encapsulate the outer surfaces of the plurality of electronic components 23 located inside the filling space to isolate the electronic components 23 from the air.

After the potting operation is completed and the potting gel is solidified, the first box 241 and the second box 242 are connected through the second fixing column 29 to form a final assembled part. For example, the first box 241 and the second box 242 may be connected and fixed through the cooperation between the fastener and the first fixing column 28.

The potting method according to this embodiment is simple, while the gel structure has a good isolation effect, which can make the electronic component 23 isolated from the air, and thus prevent the condensation from being generated at the electronic components 23 of the electric control module 20, improving the reliability, stability, and safety of the electric control module 20. In addition, when the flammable and explosive gas is present in the environment where the electric control module 20 is located, the isolation structure is provided and encapsulates the outer surfaces of the electronic components 23, which can eliminate the safety hazards of the ignition and explosion caused by the contact between flammable and explosive gas and the electronic components 23, while achieving the effects of improving the vibration resistance performance of the electric control module 20, preventing the disengagement of the electronic components 23, buffering and protecting the electronic components 23, and the dust prevention.

In the description of this specification, descriptions with reference to "an embodiment", "some embodiments", "an illustrative embodiment", "an example", "a specific example", "some examples", or the like means that a particular feature, structure, material, or characteristic described in connection with the embodiment or example is comprised in at least one embodiment or example of the present disclosure. The appearances of the above phrases in various places throughout this specification are not necessarily referring to the same embodiment or example of the present disclosure. Further, the particular features, structures, materials, or characteristics described here may be combined in any suitable manner in one or more embodiments or examples.

Although embodiments of the present disclosure have been illustrated and described, it is conceivable for those skilled in the art that various changes, modifications, replacements, and variations can be made to these embodiments without departing from the principles and spirit of the present disclosure. The scope of the present disclosure shall be defined by the claims as appended and their equivalents.

## Claims

1. An electric control module assembly, comprising:
an electric control module comprising an electric control box and an electric control component disposed in the electric control box, wherein the electric control component comprises an electric control board and a plurality of electronic components disposed at the electric control board; and
a heat dissipation component configured to dissipate heat from the electric control module,
wherein the electric control box is internally provided with an isolation structure encapsulating outer surfaces of the plurality of electronic components.

2. The electric control module assembly according to claim 1, wherein the isolation structure is a gel structure.

3. The electric control module assembly according to claim 1 or 2, wherein:
a part of the heat dissipation component is located in the electric control box and is in thermally conductive connection with the electric control component; and
a space defined by the electric control box, the electric control component, and the heat dissipation component is filled with the isolation structure, the electric control component and the part of the heat dissipation component being connected into one piece by the isolation structure.

4. The electric control module assembly according to claim 3, wherein an inner wall of the electric control box or the electric control board is provided with a first limiting structure configured to limit a position of the part of the heat dissipation component.

5. The electric control module assembly according to any one of claims 1 to 4, wherein the electric control board has a first side and a second side opposite to each other in a thickness direction of the electric control board, wherein a filling space is defined between the first side of the electric control board and the electric control box, at least part of the plurality of electronic components being disposed at the first side of the electric control board and located in the filling space, and the filling space being filled with the isolation structure.

6. The electric control module assembly according to claim 5, wherein a part of the heat dissipation component is located in the filling space and is in thermally conductive connection with the plurality of electronic components.

7. The electric control module assembly according to claim 5, wherein the isolation structure is filled between an outer edge of the electric control board and an inner wall of the electric control box.

8. The electric control module assembly according to claim 7, wherein:
the plurality of electronic components are mounted at the first side of the electric control board; and
a surface of the second side of the electric control board serves as a board back surface exposing welding pins of the plurality of electronic components, the isolation structure being flush with or protruding from the board back surface and covering the welding pins of the plurality of electronic components.

9. The electric control module assembly according to claim 5, wherein:
at least part of an inner wall of the electric control box facing towards the first side of the electric control board is formed as a profiling structure; and
a configuration of a first side of the at least part of the plurality of electronic components mounted at the first side of the electric control board is defined as a first side configuration of the electric control component, the profiling structure being similar to the first side configuration of the electric control component.

10. The electric control module assembly according to claim 9, wherein the electric control box comprises a first box and a second box that are formed independently, wherein:
a box wall of the first box encloses to define a cavity with an opening;
the box wall of the first box has a bottom wall opposite to the opening and a surrounding wall surrounding the bottom wall to form the opening, the bottom wall of the first box constituting the profiling structure;
the electric control component is fixed in the cavity of the first box; and
a space between the bottom wall of the first box and the first side of the electric control board constitutes the filling space.

11. The electric control module assembly according to claim 10, wherein the isolation structure is a gel structure formed through potting, wherein an opening side of the first box is configured as a potting side, and wherein a gel material enters the filling space through the opening of the first box.

12. The electric control module assembly according to claim 11, wherein a gap is formed between an outer edge of a board surface of the electric control board and the surrounding wall of the first box, wherein at least part of the gap constitutes a potting port in communication with the filling space.

13. The electric control module assembly according to claim 11, wherein the electric control board has a first potting hole formed on the electric control board, the first potting hole being in communication with the filling space.

14. The electric control module assembly according to claim 13, wherein:
an equivalent diameter of the first potting hole is greater than 10 mm, and/or
the first potting hole is located in a center portion of the electric control board.

15. The electric control module assembly according to claim 11, wherein the first box is internally provided with a first fixing column supported at the first side of the electric control board and a second fixing column connected to the second box, wherein the electric control board is mounted at the first fixing column, and wherein a surface of the second side of the electric control board serves as a board back surface, the second fixing column being located at an outer peripheral side of the electric control board and protruding from the board back surface.

16. The electric control module assembly according to claim 5, wherein:
the isolation structure is a gel structure;
a potting side of the filling space is located at the first side of the electric control board; and
a part of the electric control box located at the first side of the electric control board has a second potting hole formed on the part of the electric control box, the second potting hole being located at the highest level of the electric control box when the first side of the electric control board faces upwards.

17. The electric control module assembly according to claim 5, wherein:
the isolation structure is a gel structure, the heat dissipation component being led out from a potting side of the electric control box; and/or
the isolation structure is a gel structure, a wiring harness connected to the electric control component being led out from the potting side of the electric control box.

18. The electric control module assembly according to any one of claims 1 to 17, wherein the heat dissipation component comprises a heat dissipation member, the heat dissipation member comprising a heat dissipation main body located in the electric control box, wherein the heat dissipation member internally has a heat dissipation channel to allow for flow of a heat dissipation medium.

19. The electric control module assembly according to claim 18, wherein the heat dissipation component comprises a medium inlet pipe and a medium outlet pipe, the heat dissipation channel being in communication with the medium inlet pipe and the medium outlet pipe.

20. The electric control module assembly according to claim 19, wherein a plurality of heat dissipation members are provided and arranged in parallel.

21. The electric control module assembly according to claim 20, wherein:
the medium inlet pipe and the medium outlet pipe are located at two sides of the electric control board in a length direction of the electric control board;
the heat dissipation member extends in the length direction of the electric control board; and
the plurality of heat dissipation members are arranged in a width direction of the electric control board.

22. The electric control module assembly according to claim 19, wherein an inner wall of the electric control box is provided with a third limiting structure, the medium inlet pipe and the medium outlet pipe cooperating with the third limiting structure to limit positions of the medium inlet pipe and the medium outlet pipe.

23. The electric control module assembly according to claim 19, wherein a part of the medium inlet pipe and a part of the medium outlet pipe are located between an outer edge of the electric control board and an inner wall of the electric control box.

24. The electric control module assembly according to claim 18, wherein the heat dissipation member is a phase-change heat dissipation element and comprises a heat absorption segment and a heat dissipation segment, the heat dissipation medium in the heat dissipation member being adapted to circulate and flow between the heat absorption segment and the heat dissipation segment, and the heat absorption segment comprising the heat dissipation main body.

25. The electric control module assembly according to any one of claims 1 to 17, wherein the heat dissipation component comprises at least one heat dissipation member, wherein the at least one heat dissipation member comprises a heat dissipation main body located in the electric control box, the heat dissipation main body of the at least one heat dissipation member covering outer peripheral sides of the plurality of electronic components.

26. The electric control module assembly according to claim 25, wherein the at least one heat dissipation member comprises first heat dissipation members, wherein each of the first heat dissipation members has a heat dissipation main body located at the outer peripheral sides of the plurality of electronic components, the heat dissipation main body of each of at least part of the first heat dissipation members extending along a non-straight line.

27. The electric control module assembly according to claim 26, wherein the heat dissipation main body of the first heat dissipation member at least partially extends in a circumferential direction of the plurality of electronic components.

28. The electric control module assembly according to claim 26, wherein the heat dissipation main body of the first heat dissipation member comprises a bent portion or a plurality of bent portions arranged at intervals in an extending direction of the first heat dissipation member, wherein the bent portion or each of the plurality of bent portions comprises a plurality of bent segments sequentially connected in the extending direction of the first heat dissipation member, an angle being formed between two adjacent bent segments of the plurality of bent segments.

29. The electric control module assembly according to claim 28, wherein the angle between two adjacent bent segments of the plurality of bent segments ranges from 90° to 170°.

30. The electric control module assembly according to claim 28, wherein the first heat dissipation member further comprises a non-bent portion extending along a straight line, wherein one of the plurality of bent segments of the bent portion connected to the non-bent portion serves as a first bent segment, an angle between the non-bent portion and the first bent segment ranging from 90° to 170°.

31. The electric control module assembly according to claim 25, wherein the at least one heat dissipation member comprises a first heat dissipation member having a heat dissipation main body located at the outer peripheral sides of the plurality of electronic components.

32. The electric control module assembly according to claim 25, wherein:
the at least one heat dissipation member comprises a first heat dissipation member having a heat dissipation main body located at the outer peripheral sides of the plurality of electronic components, at least part of the plurality of electronic components being arranged in a length direction of the electric control board to constitute an electronic component group; and
the heat dissipation main body of the first heat dissipation member extends in a circumferential direction of electronic components of the electronic component group, and/or the first heat dissipation member is disposed at each of two sides of the electronic component group in a width direction of the electric control board.

33. The electric control module assembly according to claim 25, wherein the at least one heat dissipation member comprises a first heat dissipation member having a heat dissipation main body located at the outer peripheral sides of the plurality of electronic components, a peripheral side surface of each of the plurality of electronic components being an electronic component side surface, and the heat dissipation main body of the first heat dissipation member being in thermally conductive connection with the electronic component side surface.

34. The electric control module assembly according to claim 25, wherein:
the at least one heat dissipation member comprises a first heat dissipation member having a heat dissipation main body located at the outer peripheral sides of the plurality of electronic components, and
a plurality of heat dissipation members are provided, the plurality of heat dissipation members comprising the first heat dissipation member and a second heat dissipation member, an end surface of each of the plurality of electronic components in a height direction of the electronic component being an electronic component end surface, and a heat dissipation main body of the second heat dissipation member being in thermally conductive connection with the electronic component end surface.

35. The electric control module assembly according to claim 34, wherein the heat dissipation main body of the second heat dissipation member comprises a fixing portion and a heat dissipation portion, the heat dissipation portion having a heat dissipation channel to allow for flow of a heat dissipation medium, and the fixing portion being connected to the electric control board by a fastener.

36. The electric control module assembly according to claim 25, wherein a thermally conductive layer is disposed between the heat dissipation main body and the plurality of electronic components, the thermally conductive layer comprising one or more of a thermally conductive adhesive, thermally conductive silicone grease, a thermally conductive pad, and a thermally conductive metal.

37. The electric control module assembly according to claim 25, wherein the heat dissipation main body is formed in a flat shape, at least one side of the heat dissipation main body in a thickness direction of the heat dissipation main body being opposite to the plurality of electronic components or in thermally conductive connection with the plurality of electronic components.

38. The electric control module assembly according to claim 1, wherein:
the heat dissipation component comprises at least one heat dissipation member, each of the at least one heat dissipation member comprising a heat dissipation main body located in the electric control box; and
an inner wall of the electric control box is provided with a first limiting structure, at least part of the at least one heat dissipation member being engaged with the first limiting structure to limit a position of the at least one heat dissipation member.

39. The electric control module assembly according to claim 38, wherein the first limiting structure comprises a first limiting groove, the at least part of the at least one heat dissipation member being received in the first limiting groove.

40. A potting method of the electric control module assembly according to any one of claims 1 to 39, the potting method comprising:
assembling the electric control component and the heat dissipation component into the electric control box to form a pre-assembled assembly;
adjusting the pre-assembled assembly to orient a potting side of the electric control box to face upwards; and
potting gel into the electric control box from the potting side of the electric control box to form the isolation structure.

41. The potting method according to claim 40, wherein:
said assembling the electric control component and the heat dissipation component into the electric control box to form the pre-assembled assembly comprises:
assembling a part of the heat dissipation component to the electric control component, assembling the electric control component assembled with the heat dissipation component into a first box of the electric control box, and orienting a first side of the electric control board toward the first box, wherein the first side of the electric control board is provided with the plurality of electronic components;
said adjusting the pre-assembled assembly to orient the potting side of the electric control box to face upwards comprises:
adjusting the pre-assembled assembly to orient a second side of the electric control board to face upwards; and
said potting the gel into the electric control box from the potting side of the electric control box to form the isolation structure comprises:
potting the gel into the first box from the second side of the electric control board to form the isolation structure, and assembling a second box of the electric control box to the first box.

42. An outdoor unit, comprising:
an outdoor unit casing;
an outdoor heat exchanger and an outdoor fan that are disposed in the outdoor unit casing;
a compressor assembly disposed in the outdoor unit casing; and
an electric control module assembly according to any one of claims 1 to 39, the electric control module assembly being disposed in the outdoor unit casing.

43. The outdoor unit according to claim 42, wherein a refrigerant circulation system of the outdoor unit comprises a cooling portion configured to dissipate heat from the electric control module, the cooling portion being in thermally conductive connection with the heat dissipation component, or at least part of the cooling portion constituting the heat dissipation component.

44. The outdoor unit according to claim 43, further comprising:
a water-circuit heat exchange assembly comprising a water-circuit heat exchanger, wherein the water-circuit heat exchanger has a water flow channel and a refrigerant channel exchanging heat with each other, wherein the cooling portion is connected between the refrigerant channel of the water-circuit heat exchanger and the outdoor heat exchanger.

45. A heating, ventilation and air conditioning equipment, comprising an outdoor unit according to any one of claims 42 to 44.
